(19) **Europäisches Patentamt**
**European Patent Office**
**Office européen des brevets**

(11) **EP 1 709 651 B1**

(12) **EUROPEAN PATENT SPECIFICATION**

(45) Date of publication and mention
of the grant of the patent:
**21.09.2016 Bulletin 2016/38**

(51) Int Cl.:
*H01G 9/20* (2006.01)    *H01L 31/04* (2006.01)
*H01L 31/18* (2006.01)

(21) Application number: **05704233.5**

(22) Date of filing: **21.01.2005**

(86) International application number:
**PCT/JP2005/001180**

(87) International publication number:
**WO 2005/071704 (04.08.2005 Gazette 2005/31)**

(54) **METAL OXIDE DISPERSION, METAL OXIDE ELECTRODE FILM, AND DYE SENSITIZED SOLAR CELL**

METALLOXIDDISPERISION, METALLOXID-ELEKTRODENFILM UND FARBSTOFFSENSIBILISIERTE SOLARZELLE

DISPERSION D'OXYDE METALLIQUE, FILM D'ELECTRODE D'OXYDE METALLIQUE ET PILE SOLAIRE SENSIBLE AUX COLORANTS

(84) Designated Contracting States:
**AT BE BG CH CY CZ DE DK EE ES FI FR GB GR HU IE IS IT LI LT LU MC NL PL PT RO SE SI SK TR**

(30) Priority: **22.01.2004   JP 2004014971**
**22.01.2004   JP 2004014987**
**26.11.2004   JP 2004342808**

(43) Date of publication of application:
**11.10.2006 Bulletin 2006/41**

(60) Divisional application:
**14192991.9 / 2 843 675**

(73) Proprietor: **SHOWA DENKO K.K.**
**Tokyo 105-8518 (JP)**

(72) Inventors:
• **KAYAMA, Susumu**
**c/o Showa Titanium Co. Ltd.**
**Toyama-shi, Toyama 9318577 (JP)**
• **WAKIZAKA, Yasuaki**
**c/o Showa Titanium Co. Ltd.**
**Toyama-shi, Toyama 9318577 (JP)**
• **KONDO, Kunio**
**c/o Corporate R & D Center**
**Midori-ku, Chiba-shi**
**Chiba 2670056 (JP)**

(74) Representative: **Strehl Schübel-Hopf & Partner**
**Maximilianstrasse 54**
**80538 München (DE)**

(56) References cited:
**EP-A- 1 363 348      WO-A-02/075826**
**US-A- 5 525 440      US-A1- 2002 182 310**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a metal oxide dispersion capable of producing an electrode suitable for use in solar cells and the like, and a producing and coating method thereof. Further, the present invention relates to an electrode of a metal oxide film having a high mechanical strength suitable for use in solar cells and the like, and a producing method and use thereof.

Background Art

At present, the solar cell is predominatly a silicon-type solar cell, but in view of the harmful raw materials used, high production cost and the like, studies are being made to develop a new type of solar cell.

One of thus-developed solar cells is a dye-sensitized solar cell. Since Graetzel et al. of EPFL-Lausanne reported it in 1991 (see, for example, M. Graezel, Nature, 353, 737 (1991)), this solar cell has been studied and developed as an alternative to the silicon solar cell.

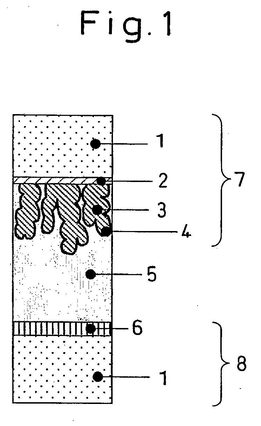

The dye-sensitized solar cell, in general, has a structure shown in Fig. 1 and comprises the three portions of a dye electrode 7, an electrolytic layer and a counter electrode. Here, the dye electrode 7 indicates an electrode where a metal oxide layer (e.g., titanium dioxide) bound with a sensitizing dye is formed on an electrode substrate such as an electrically conducting glass 1. In Fig.1, an optional under-coating layer 2 is located between the electrode substrate such as an electrically conducting glass 1. The counter electrode 8 indicates an electrode where a catalyst layer such as platinum or graphite is formed on an electrode substrate such as an electrically conducting glass. The electrolytic layer 5 is a solution having dissolved therein an electrolyte, and this is a portion sandwiched by the dye electrode and the counter electrode. The electrode substrate, as used herein, indicates an electrode substrate (e.g., glass, organic polymer) on which FTO, ITO or the like is coated and dried.

The mechanism of photoelectric conversion is described as follows.

First, the sensitizing dye absorbs light to generate an electron and a hole. The generated electron reaches the electrode substrate through the metal oxide layer and is taken outside. On the other hand, the generated hole is transferred to the counter electrode through the electrolytic layer and combines with an electron supplied through the electrode substrate.

As an index showing the characteristics of the dye-sensitized solar cell, a photoelectric conversion efficiency represented by the following formula is known.

$$\eta(\%) = Jsc \times Voc \times FF/incident\ light\ energy \times 100$$

(wherein $\eta$ is a photoelectric conversion efficiency, Jsc is a short-circuit current density [mA/cm$^2$], Voc is an open voltage [V], FF is a fill factor [-], and the incident light energy is an incident light energy per unit area [mW/cm$^2$]).

The photoelectric conversion efficiency $\eta$ depends on the performance of the dye electrode. The performance of the dye electrode is enhanced, for example, by enlarging the surface area of the metal oxide per unit to increase the amount of the sensitizing dye supported and to increase the number of electrons generated, increasing the contact of titanium dioxide particles with each other to improve the electronic conductivity, enhancing diffusion of electrolyte, increasing the necking of metal oxide particles with each other and intensifying the adhesion between the metal oxide particle and the dye electrode substrate to attain smooth electron transfer.

These methods are described below by using titanium dioxide as an example of the metal oxide.

As for the method of enlarging the surface area of metal oxide per unit, a method of using titanium dioxide having a pore inner diameter of 3 to 10 nm is described (see, for example, JP-A-2001-283942 (the term "JP-A" as used herein means an "unexamined published Japanese patent application"). In this method, a sol prepared from titanium tetrachloride is heated and dried to obtain the titanium dioxide particle.

As for the method of increasing the necking of metal oxide particles, i.e. a structure wherein a few particles are connected with each other (partial face contact), a method of forming a titanium dioxide layer on a substrate such as electrically conducting glass and then treating it with titanium tetrachloride has been proposed (see, for example, C.J. Barbe et al., J. Am. Ceram. Soc., 80, 3157 (1997)). Here, the titanium tetrachloride has a function of reacting with a titanium dioxide particle to generate a new bond and thereby cause necking of particles with each other.

JP-A-2003-308890 discloses a technique of performing a corona treatment so as to enhance the adhesion between the electrode and the resin substrate.

On the other hand, as for the method of intensifying the adhesion between the titanium dioxide particle and the dye electrode substrate, when the electrode substrate is an electrically conducting glass, a method of coating a titanium dioxide liquid dispersion on the electrode substrate and baking it at 400°C or more, using an electric furnace or the like, is known. According to this method, the hydroxyl group on the titanium dioxide particle surface and the hydroxyl group of the electrically conducting substance on the electrode substrate are chemically bonded through dehydration condensation.

With respect to the production of a dye-sensitized solar cell using a resin for the electrode substrate, several techniques have been reported.

For example, a technique of sintering the metal oxide at a high temperature by using a heat-resistant metal foil as the electrode substrate on the dye electrode side (see, for example, JP-A-11-288745), and a technique of treating the electrode substrate by anodization or chemical oxidation (see, for example, JP-A-10-112337) have been reported.

A technique of using a flexible resin as the electrode substrate and sintering the metal oxide at a low temperature has been also reported (see, for example, B.A. Gregg et al., Langmuir, 2000, Vol. 16, 5626). In this case, a resin which is inexpensive as compared with the above-described metals and which is transparent and resistant against corrosion by the electrolyte can be used as the electrode substrate of the dye electrode and therefore, a dye-sensitized solar cell exhibiting high performance while making use of the properties of the resin substrate can be expected. According to this method, a dense metal oxide film is formed at a low temperature and, thereby, adhesion of metal oxide fine particles to each other can be attained without applying a heat treatment at a high temperature.

Disclosure of Invention

As stated in above JP-A-2001-283942 and C.J. Barbe et al., J. Am. Ceram. Soc., 80, 3157 (1997), various studies have been heretofore made with an attempt to accelerate the electron transfer within the electrode. However, resistance at the interface between the electrode substrate and the metal oxide layer is also present as a resistance component inside the cell and in the case of a resin substrate having poor wettability to a metal oxide dispersion as compared with the glass substrate, this resistance component constitutes a large factor of decreasing the performance of the cell as a whole.

In the case that the corona treatment is used so as to enhance the adhesion between the electrode and the resin substrate according to the method of JP-A-2003-308890, only a thin titanium dioxide layer having low crystallinity can be obtained by merely coating a watersoluble photocatalyst particle. Therefore, a low-resistance titanium dioxide electrode capable of satisfactorily serving as a porous electrode cannot be formed.

In the case that the hydroxyl group on the titanium dioxide particle surface and the hydroxyl group of the electrically conducting substance on the electrode substrate are chemically bonded through dehydration condensation, titanium dioxide particles are also sintered with each other to decrease the specific surface area and, as a result, the amount of the dye supported is also decreased. In the case where the electrode substrate is a resin, the temperature cannot be elevated more than the heat-resistant temperature of the substrate, but the dehydration condensation generally less proceeds in the temperature region lower than the heat-resistant temperature of the resin (for example, in the case of polyethylene terephthalate, about 150°C or less) and therefore, the adhesion cannot be enhanced by the baking.

In the case that a resin is used as the electrode substrate of a dye-sensitized solar cell according to the method of JP-A-11-288745 and JP-A-10-112337, since these electrode substrates are opaque, when they are applied in a dye-sensitized solar cell, the light must be introduced from the counter electrode side in use. This causes problems, for example, the light is largely absorbed in the electrolytic layer and less light reaches the dye electrode and, as the majority of electrons generated are obtained in the metal oxide film at the portion remotest from the electrode substrate, the electron transfer or the like is limited due to electric resistance of the metal oxide and, as a result, the photoelectric conversion efficiency greatly decreases. Furthermore, the substrate of the sheet-like electrode, which is resistant against corrosion by iodine used as the electrolyte of the dye-sensitized solar cell, is limited to expensive metals such as titanium, tantalum and niobium and therefore, the dye-sensitized solar cell produced by such a method is disadvantageously expensive.

In the case that a dense metal oxide film is used to adhere metal oxide fine particles to each other according to the method of above B.A. Gregg et al., Langmuir, 2000, Vol. 16, 5626, the metal oxide film cannot be made porous and this causes a problem that the produced photoactive electrode is very low in performance as compared with conventional porous photoactive electrodes produced through high-temperature heat treatment.

Even if a porous metal oxide film can be formed by this method, since sintering at a high temperature is not performed, it is estimated that the adhesive strength between metal oxide fine particles is not sufficiently high and the mechanical strength of the metal oxide film is insufficient. Therefore, it is estimated that the contact of metal oxide fine particles to each other is impaired, for example, by a slight mechanical vibration received by the metal oxide electrode or a temperature change received by the cell. In other words, the dye electrode produced by this method is considered to fail in maintaining its performance over a long period of time.

An object of the present invention is to solve the above-described problems, and provide a metal oxide dispersion capable of enhancing the adhesion to the substrate and maintaining good conduction between the metal oxide layer and the electrically conducting resin, and a coating method thereof.

Another object of the present invention is to solve the above-described problems, and provide an electrode with a metal oxide film ensuring adsorption of a large amount of a sensitizing dye, smooth electron transfer and high mechanical strength, which is suitable for use in solar cells and the like, and a production method thereof.

As a result of intensive studies by taking account of those problems, the present inventors have found a method capable of enhancing the adhesion to the substrate, maintaining good conduction between the metal oxide layer and the electrically conducting resin, and producing a solar cell having high photoelectric conversion efficiency, and succeeded in attaining the above-described object.

More specifically, the present invention is defined by the technical features of claim 1.

Brief Description of Drawings

Fig. 1 A cross section roughly showing the construction of a dye-sensitized solar cell.
Fig. 2 An electron microphotograph showing the necking state of titanium dioxide particles.
Fig. 3 A graph showing the relationship between the absorbance pattern and the absorption edge of titanium dioxide particle.
Fig. 4 A Nyquist plot for Example 1.
Fig. 5 A Nyquist plot for Comparative Example 4.

Best Mode for Carrying Out the Invention According to the preferred embodiment of the present metal oxide dispersion, a metal oxide structure capable of realizing easy film formation on an electrically conducting resin, a large amount of adsorption of the sensitizing dye and smooth electron transfer, and a production method thereof are provided.

A dye-sensitized solar cell having high photoelectric conversion efficiency can be obtained from the metal oxide structure formed from the metal oxide dispersion according to the preferred embodiment of the present invention, and therefore the present invention has practical value in industry.

According to the preferred embodiment of the present metal oxide electrode, a material incapable of maintaining its performance at a high-temperature heat treatment performed in the production process of conventional dye-sensitized solar cells can be used for a dye-sensitized solar cell, and a flexible dye-sensitized solar cell can be obtained.

Metal Oxide Dispersion

The metal oxide dispersion capable of producing a dye-sensitized solar cell electrode on an electrically conducting resin substrate (hereinafter, unless otherwise indicated, sometimes simply referred to as a "metal oxide dispersion") of the present invention is obtained by mixing metal oxide powders with a dispersion medium such as water or organic solvent. This dispersion is sometimes called a slurry when the viscosity is low, and called a paste when the viscosity is high.

The metal oxide dispersion of the present invention comprises a metal oxide particle group blended for imparting an objective function to the dye-sensitized solar cell electrode, and a component for bonding this particle group to impart the strength as a film, and in many cases, further comprises a solvent or the like for preparing a coating material therefrom, and an additive or the like for enhancing the dispersion stability and coatability of the coating material.

Metal Oxide Particles

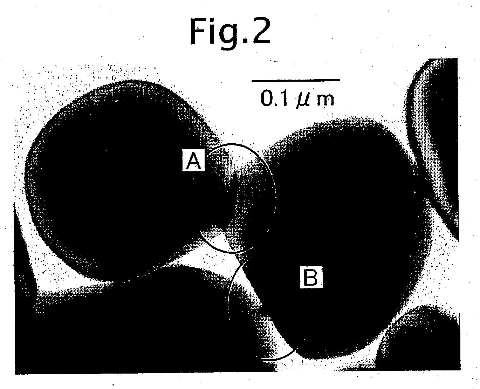

Usually, particles mixed with each other form only a point contact portion, but the metal oxide particles for use in the preferred embodiment of the present invention are characterized by having a necking structure (partial face contact structure) as shown in Fig. 2, where a plurality of particles of the raw material themselves are combined to each other. In Fig. 2, A indicates a necking part, and B indicates a point contact part. By virtue of this structure, the metal oxide (particularly, titanium dioxide) electrode formed of the metal oxide dispersion according to the preferred embodiment of the present invention has a small electric resistance, and the cell produced by using the electrode has good properties.

For example, a nanometer-scale titanium dioxide can be obtained by hydrolyzing titanyl sulfate or the like in a liquid phase, but in the titanium dioxide structure electrode formed thereof, the electronic resistance is large due to small heat history at the synthesis, low crystallinity and little formation of a necking structure. On the other hand, a titanium dioxide particle group obtained by a so-called vapor phase process of reacting titanium tetrachloride or the like with an oxidative gas such as oxygen at a high temperature has high crystallinity owing to high heat history at the synthesis and at the same time, this titanium dioxide has a necking structure owing to sintering or the like. When the titanium dioxide obtained by the vapor phase process has a small particle diameter, and by using this as the raw material, a metal oxide dispersion capable of producing a metal oxide electrode having two properties essential as the electrode, that is, (i) high electronic conductivity and (ii) high specific surface area, can be provided. The production method by this vapor phase process is not particularly limited, but the titanium dioxide can be synthesized by the method described, for example, in WO01/16027, JP-A-6-304423 and JP-B-36-3359 (the term "JP-B" as used herein means an "examined Japanese patent publication"). The production method of vapor-phase-process titanium dioxide is described below.

In the metal oxide constituting the metal oxide dispersion according to the preferred embodiment of the present invention, at least one particle group is preferably a powder obtained by the vapor phase process. According to the vapor phase process, a powder having a relatively narrow primary particle diameter distribution can be obtained as compared with other production methods and therefore, when this powder is used as Particle Group A or B described later, a primary particle diameter distribution preferred as the metal oxide structure is readily obtained.

For the metal oxide dispersion capable of producing a dye-sensitized solar cell electrode on an electrically conducting resin substrate, a dispersion obtained by mixing a metal oxide powder having an average primary particle diameter of 100 nm to 1 $\mu$m as converted from the specific surface area determined by the BET method (referred to as Particle Group A), and a metal oxide powder having an average primary particle diameter of 5 to 40 nm (referred to as Particle Group B) with use of a dispersion medium such as water or organic solvent is preferably used. Assuming that the particle is sphere, if particles have only one kind of diameter, the filling ratio is as low as 74% even when filled at a highest density. However, by blending particles having a plurality of diameters, small particles intrude into the space between large particles and the filling ratio can be elevated. Particle Group A is a relatively large particle in the present invention but because of its characteristic feature that the size is sufficiently small to allow for regarding the entire particle as a semiconductor surface and the crystallinity is high, this particle is considered to undertake the main electron transfer in the metal oxide electrode formed. By blending Particle Group B, a porous body having a large coordination number for Particle Group A, high filling ratio and good electronic conductivity as the electrode can be formed.

Particle Group B may have almost a single particle diameter, but two or more particle groups differing in the production method, particle size or the like may be present therein. In Particle Group B, two kinds of Particle Groups C and D are preferably present. More specifically, Particle Group C is preferably a particle group having a primary particle diameter of 20 nm or more, and Particle Group D is preferably a particle group having a primary particle diameter of less than 20 nm.

Particle Group A constituting the metal oxide dispersion mainly acts on light intruded into a solar cell to scatter the light inside the cell and thereby elevate the light absorption efficiency. It is known that the dye-sensitized solar cell absorbs light over the region from ultraviolet to near infrared to generate an electron, and that the light scattering becomes maximum at a point where the particle diameter is about a half of the wavelength of the light to be absorbed by a sensitizing dye or the like, and becomes weak as the particle size deviates therefrom (see, Manabu KIYONO, Sannka Titan (Titanium Dioxide), Gihodo, p. 129 (1991)). In order to scatter light over the region from ultraviolet to near infrared, the average primary particle diameter is preferably from 100 nm to 1 $\mu$m. The particle diameter can also be selected depending on the wavelength of the light intended to be scattered.

Particle Group B has a role of supporting a sensitizing dye and transmitting an electron generated by the sensitizing dye. The sensitizing dye is supported on the metal oxide through a chemical bond with the surface hydroxyl group or metal atom (hereinafter referred to as a "dye binding part") of metal oxide, and transfers an electron to the metal oxide through the bound. Therefore, as the amount of sensitizing dye bound to the metal oxide increases, the number of electrons transferred increases. The metal oxide particle is known to have from 9 to 14 surface hydroxyl groups/nm$^2$ on the surface thereof (see, Manabu KIYONO, Sannka Titan (Titanium Dioxide), Gihodo, p. 129 (1991), supra), and as the metal oxide has a larger specific surface area, a larger number of dye binding parts are produced. The specific surface area of Particle Group B suitable for solar cells is from about 40 m$^2$/g to about 300 m$^2$/g, preferably from about 60 m$^2$/g to about 250 m$^2$/g, and in terms of the average primary particle diameter, from about 5 nm to about 40 nm, preferably from about 6 nm to about 25 nm. If the particle group has an average primary particle diameter of less than about 5 nm, the crystallinity is generally low to fail in performing smooth electron transfer and therefore, this is not suitable for use as the main component constituting the electrode of a solar cell. The low crystallinity is ascribable to the heat history being kept low at the synthesis so as to prevent the particle growth. If the particle group has an average primary particle diameter exceeding about 40 nm, the specific surface area is small and the dye adsorption amount becomes insufficient. The blending ratio of Particle Group A and Particle Group B is, in terms of the mass ratio, A/B = from 5/95 to 30/70, preferably A/B = from 10/90 to 20/80.

In the present invention, as described above, if particles of 20 nm or less (Particle Group D) are used as the main component, the electron transfer does not proceed smoothly and the performance of the solar cell sometimes decreases. However, when particles of 20 nm or more (Particle Group C) are present as the main component and particles having a diameter of 20 nm or less are filled in the void, this may promote the electron transfer within the electrode and the dye adsorption amount may be made larger than that when only Particle Group C is used. The blending ratio of Particle Group C and Particle Group D is, in terms of the mass ratio, C/D = from 95/5 to 70/30, preferably C/D = from 95/5 to 80/20.

The particle of Particle Group D is not particularly limited in its production method as long as it has a small diameter as compared with Particle Group C but, as described above, particles having higher crystallinity can realize good electronic conductivity and good property as the electrode.

The specific surface area of Particle Group C suitable for solar cells is from about 40 m$^2$/g to about 75 m$^2$/g, preferably from about 60 m$^2$/g to about 70 m$^2$/g, and in terms of the average primary particle diameter, from about 20 nm to about 40 nm, preferably from 21 nm to about 25 nm. The specific surface area of Particle Group D is from about 75 m$^2$/g to about 300 m$^2$/g, preferably from about 100 m$^2$/g to about 275 m$^2$/g, and in terms of the average primary particle diameter, from about 5 nm to about 20 nm, preferably from 5.5 nm to about 15 nm. The characteristic feature required for Particle Groups C and D includes dye-adsorbing ability. In general, as described above, the electronic conductivity is enhanced by increasing the particle diameter and the dye-adsorbing ability per unit mass is enhanced by decreasing the particle diameter. Therefore, a particle diameter range preferred as the solar cell electrode material is present. In order to attain good filling as the entire Particle Group B and thereby increase the electronic conductivity and dye adsorption amount, a significant difference is preferably present between the particle diameter of Particle Group C and the particle diameter of Particle Group D.

As described above, when a necking particle group, particularly, a vapor-phase grown necking particle group is present in the metal dispersion, the electron transferability of the electrode obtained is elevated, but it is also found that when a necking particle group is comprised, the film formed is enhanced in the following properties and is optimal as an electrode for dye-sensitized solar cells.

(a) Formation of Film Having High Strength

One of the properties required of the electrode film is high film strength. The metal oxide dispersion obtained by the preferred embodiment of the present invention is, as one of the purposes thereof, coated on a plastic substrate and the film formed preferably has great strength particularly against bending so that the plastic substrate can exert its flexibility. Also, after the electrode film formation, a,separator is sometimes used to maintain the electronic insulation from the counter electrode and the electrode is preferably not separated even when physically contacted with the separator.

When the liquid dispersion comprising a particle group (for example, Particle Group F) having a necking structure of the present invention is used, as shown in Fig. 2, some points of the necking particle group come into contact with the substrate surface, whereby the electrode film obtained from the liquid dispersion is fixed to the substrate. By blending a necking particle group having such an anchor effect, the film strength is enhanced. As another effect, the necking particle group is considered to have a function of decreasing the freedom degree of other particle groups (for example, Particle Group G) by forming a three-dimensional structure, that is, a function as a framework supporting the entire film structure.

(b) Reduction of Binding Component Amount

In the case of comprising a particle group having a necking structure, the amount of the binding component can be decreased by the portion of the necking structure, nevertheless, the film strength is enhanced. The film strength is enhanced also for the above-described reasons. Therefore, the film can be formed by decreasing the amount of the binding component as compared with conventional film formation techniques or by not using a binding component at all. As a result, the inhibition by the binding component on the properties of the particle group can be minimized or nulled.

(c) Formation of Film Having High Electrode Performance

As described above, when a necking particle group is used, the binder amount can be decreased and therefore, the function as a metal oxide of the metal oxide particle group can be fully exerted. The dye electrode of a dye-sensitized solar cell is required to be a porous film because the electrolyte from which an electron is accepted must be contacted with the dye on the metal oxide particle surface. Furthermore, in order to prevent back electron transfer due to defects and increase the ratio of the objective electron path, high crystallinity is also desirable. The surface crystal of the particle having necking is continued to an adjacent particle without losing the properties as a particle and this enables formation of a metal oxide porous electrode film having a longer-distance crystalline order than that of a single particle. , (d) Enhancement of Coatability

The characteristic features required of the metal oxide liquid dispersion for the formation of an electrode film are described above by referring to respective items. However, not only the performances as the electrode after film formation but also thixotropy and leveling properties allowing for easy wetting or an even coating are necessary. Considering the wettability or dispersion of the particle group, when the oxide particle group is, for example, a titanium dioxide-based particle group, a solvent having a relatively high vapor pressure at an ordinary temperature, such as alcohol, is used in many cases as in the present invention. At this time, if only Particle Group G is used, the drying of the liquid dispersion after coating is difficult to control and liquid dripping or uneven coating is liable to remain and gives rise to reduction of strength and deterioration of a design property. On the other hand, the liquid dispersion comprising a necking particle group is excellent in the thixotropy and leveling properties and liquid-holding property after coating, and partial occurrence of uneven drying and in turn, generation of liquid sagging mark can be prevented. The reason why such improvement of properties and prevention of rapid drying can be obtained when a necking particle group is blended is not clearly known, but it is considered that the complicated necking structure formed by the necking particle group takes part in improving the coatability of liquid dispersion and holding the liquid.

(e) Reduction of Tack Property

The metal oxide film in general has high tack property and when the film surface is stroked by a hand, the touch is not smooth. This is considered to occur due to chemical affinity or physical interaction between the particle group surface and the hand. Therefore, if the electrode film has high tack property, even a soft material such as separator or resin counter electrode causes film separation. The film strength test includes a pencil strength test assuming that a sharp-pointed material contacts with the film, but a film having tack property is, even if the film has sufficiently high strength in this pencil strength test, sometimes separated on rubbing the surface thereof. The film comprising the necking particle group of the present invention is decreased in the tack property and causes less separation even when the surface thereof is rubbed. The mechanism of decreasing the tack property is not clearly known, but it is considered that a part of the necking particle group protrudes from the film, whereby the smooth film comprising a particle group other than the necking particle group and the medium of rubbing the surface, such as resin electrode, are prevented from contacting with each other on respective faces or the necking particle group having a high structural strength preferentially comes into contact with the objective, as a result, the film strength is maintained.

As described above, in a preferred embodiment of the present invention, the liquid dispersion comprises a necking particle group. The liquid dispersion may have a low viscosity allowing for spray coating, dip coating or flow coating or may have a high viscosity allowing for coating by a squeegee method or a doctor blade method.

The necking particle group and other particle groups preferably have an appropriate degree of necking. When the system where a necking particle group, other particle groups and a binder component are present is measured by using a laser Doppler-type particle size distribution meter, it can be confirmed that the particle size distribution has at least two peaks. In the present invention, the particle size distribution is preferably defined by using ELS-800 (manufactured by Otsuka Electronics Co., Ltd.). The measuring method is described below.

A measurement sample is diluted with a guaranteed ethanol (produced by Kanto Chemical Co., Inc.) to a powder concentration of 0.07 mass%, and 150 ml of the resulting solution is weighed into a 200 ml-volume PYREX (Trade Mark)-made glass vessel and irradiated for 1 minute by using an ultrasonic cleaner, Iuchi ultrasonic cleaner VS-70U (output: 65 W, water bath volume: 800 ml), to obtain a sample. The liquid sample is filled to a normal amount indicated on a polystyrene-made angular cell, Ultra-Vu Disposable Cuvettes (produced by Elkay), having an inner dimension of 10-mm square and measured. The variables set at the measurement are as follows.

The measurement system is set at a constant temperature of 25°C and the Malcat method is used for the distribution analysis. The number of integrations is 100. The measurement mode is a time interval method. The sampling time is 20 $\mu$sec and the number of intake channels is 512. By using the homodyne method, the optimal light quantity, minimum light quantity and maximum light quantity are set to 10,000, 5,000 and 20,000, respectively. The analysis is performed with an ethanol viscosity of 1.10 cP, a refractive index of 1.3595 and a dielectric constant of 24.5. In the initial setting of the apparatus, the results of the coarse particle side become small due to the dust cut function, but in this measurement, the dust cut function is turned off because the necking particle group sometimes appears in the portion of several $\mu$m. At the time when the fluctuation of intensity measured by a scattering intensity monitor falls within 20% on the 100 count, the measurement is started. The ratio of the necking particle group to other particle groups is determined by area-integrating the mass distribution of particles.

In order to keep the structure and express the properties described above, the necking particle group (F), having a relatively large particle diameter defined as above, preferably exhibits a particle size distribution in the metal oxide liquid dispersion such that the mode size is 2 times or more that of Particle Group G. If the particle diameter is too large, the necking particle group protrudes from the electrode film and this causes film separation. Therefore, the necking particle group preferably exhibits a particle size distribution having a peak at 5,000 nm or less in the liquid dispersion. However, the particle group exhibiting such a particle size distribution is sheared and deflocculated at the coating and may be present as a particle smaller than that in the coating film.

The particle group (for example, Particle Group G) having a relatively small particle diameter, which is a particle group other than the necking particle group, is preferably present in the liquid dispersion to have a particle size of 5 to 400 nm. This particle group is preferably close to a primary particle so as to fill voids of the necking particle group but, as a binder component is present in the liquid dispersion, it is difficult, in practice, for it to be present in the completely primary particle state. This particle group may be aggregated and measured as a particle having a particle size tens of times the primary particle. The particle size distribution of the necking group preferably has a peak at a position of 50 to 4,000 nm, more preferably from 10 to 300 nm.

As for the necking particle group comprised in the liquid dispersion, its particle size distribution can also be defined by using a laser diffraction-type particle size distribution meter SALD-2000J (manufactured by Shimadzu Corporation). When measured by using a laser diffraction-type distribution meter, the peak of the particle group other than the necking particle group, which is observed by using a laser Doppler-type particle size distribution meter, is close to the lower limit in the particle size measurement and, probably because of this, the peak is sometimes not clearly observed, but at least the necking particle group comprised in the liquid dispersion can be specified. The measuring method by a diffraction-type particle size distribution meter is described below.

A sample is diluted with a guaranteed ethanol to a concentration of 0.05 mass% and the diluted sample is charged into a measuring system until the diffraction light intensity by SALD-2000J reaches the measurement region. At this time, the measuring system is also thoroughly displaced and filled with ethanol in advance. The analysis is performed with a powder refractive index of 2.50 to 0.1i (i is an imaginary number).

When measured by this method, the particle group for use in the preferred embodiment of the present invention preferably has a peak at least at 0-2 to 4 $\mu$m in the volume particle size distribution. When a peak is present at 0.2 $\mu$m or more, the liquid dispersion can readily exert the properties (a) to (f) of the present invention, but if the peak position exceeds 4 $\mu$m, the particle protrudes from the film formed of the liquid dispersion and this sometimes causes film separation. In order to fully exert the properties (a) to (f), the peak position is preferably from 0.4 to 3 $\mu$m.

In a preferred embodiment of the present invention, the particle in the liquid dispersion comprises a particle having many necking structures and a particle having few necking structures. In this case, the dry powder of the liquid dispersion, that is, the mixture of a necking particle group and a particle group having few necking structures, preferably has an average primary particle size of 5 to 50 nm as converted from a BET specific surface area, and more preferably 7 to 50 nm. The calculation method is shown by formula (2) later. If a particle of less than 5 nm is to be prepare, this may cause difficulty in the production, whereas if the primary particle size exceeds 50 nm, the total surface area of the electrode prepared from the oxide liquid dispersion decreases and the film properties may be impaired.

The metal oxide liquid dispersion can be produced by blending a raw material of the necking particle group and a raw material of the particle group less having a necking structure.

In the case where m particles in the necking particle group are connected to form a necking structure, the number of connected particles in the particle group having few necking structures is preferably 1/2 or less the number of connected particles in the necking particle group (that is, 0.5m or less), more preferably 1/5 or less (0.2m or less). As for the particle group having few necking structures, even when primary particles are as-is present without undergoing necking at all, the purpose in the present invention can be achieved. More specifically, the number of necking particles in the particle group having few necking structures is preferably from 0.000000001m to 0.2m on average, more preferably from 0.0000001m to 0.1m on average.

The number of necking particles in the necking particle group may be determined by the observation through a microscope such as TEM and SEM, but the number of particles is very large and the visual field of the microscope is limited. Therefore, assuming that the particle diameter by the laser diffraction-type particle size distribution meter is DL (a so-called D50 value), the tap density (a measured value according to JIS K-5101-20.2) is P, the primary particle diameter by the BET method is D1 and the true density of titania is $\rho$, the number m of necking particles is determined by the following formula:

$$m = \frac{P \times (4 / 3) \pi (DL \times 1 / 2)^3}{\rho \times (4 / 3) \pi (D1 \times 1 / 2)^3} \quad \cdots \quad (1)$$

In the measurement of the DL value of the raw material powder, a laser diffraction-type particle size distribution meter is used similarly to the measurement of particle size distribution of the liquid dispersion, but the measuring method differs as follows because the objective is powder.

An aqueous 10% sodium hexametaphosphate solution (100 $\mu$l) is added to 50 ml of a water slurry comprising titanium dioxide in an amount of 0.05 g in terms of powder and irradiated with ultrasonic waves (46 KHz, 65 W) for 3 minutes. This slurry is subjected to the measurement of particle size distribution by using a laser diffraction-type particle size distribution meter (SALD-2000J, manufactured by Shimadzu Corporation).

The primary particle diameter D1 of the necking particle group or the particle group less having a necking structure means an average primary particle diameter determined according to formula (2) from the specific surface area as measured by the BET method in terms of the specific surface area of a spherical particle.

$$D1 = 6/\rho S \qquad\qquad (2)$$

(wherein $\rho$ is a true density of particle, and S is a specific surface area of particle).

The number of necking particles in the necking particle group can be analyzed by the particle size distribution, TEM or the like, but it is preferred to measure the particle size distribution. The particle size of the particle group less having a necking structure is close to the lower limit of the measuring range in the measurement by a laser diffraction-type meter and for performing an exact analysis, the above-described laser Doppler-type particle size distribution meter is used. The sample is also prepared by the same method as described above for the measurement using ELS-800. However, the sol is not formed into dry particles, but a sample in the sol state is diluted as-is to a normal concentration and used as the measurement sample. Assuming that the particle diameter of giving a highest scattering light intensity is DL and the tap density of dry powder is P, the number m of necking particles is determined according to formula (1).

In many cases, the necking particle group and G for use in the present invention each differs in the aggregated state between when the individual particle are measured of the particle size distribution and when the necking particle group, the particle group having few necking structures and if desired, a binder are mixed and measured of the particle size distribution.

The average primary particle diameter of the necking particle group as calculated by formula (2) is preferably from 7 to 200 nm. If the average primary particle diameter is less than 7 nm, the necking particle group may be used but the cost is highly due to poor productivity, whereas if it exceeds 200 nm, the particle group may be used but the total specific surface area of the film decreases and a high-performance electrode film can hardly be obtained from the oxide liquid dispersion comprising this particle group.

The production method of general titanium dioxide by a vapor phase process is known and not particularly limited, but when titanium tetrachloride is oxidized by using an oxidative gas such as oxygen or water vapor under a reaction condition of about 1,000°C, fine particulate titanium dioxide is obtained. Examples of the preferred reaction mode include the production method described in JP-A-2001-357899. The production method of titanium dioxide used as a raw material in the present invention is described in more detail below.

The growth mechanism of particle in the vapor phase process is roughly classified into two types. One is CVD (chemical vapor deposition) and another is growth by collision (coalescence) or sintering of particles. In order to obtain ultrafine particulate titanium dioxide as an objective in the present invention, the growth time is preferably made short in either case. More specifically, in the former growth, the growth can be suppressed, for example, by elevating the preheating temperature and enhancing the chemical reactivity (reaction rate). In the latter growth, the growth by sintering or the like can be suppressed by swiftly performing cooling, dilution or the like after the completion of CVD and thereby reducing the high-temperature residence time as much as possible.

In the vapor phase process of producing titanium dioxide by oxidizing a titanium tetrachloride-comprising gas with an oxidative gas at a high temperature, the titanium tetrachloride-comprising gas and the oxidative gas each is preferably preheated to 500°C or more, because the growth by CVD can be suppressed. A fine particulate titanium dioxide having a BET specific surface area of 3 to 200 $m^2/g$, preferably from 50 to 150 $m^2/g$, may be obtained and used as the raw material.

The gas comprising titanium tetrachloride working out to a raw material preferably has a titanium tetrachloride concentration of 10 to 100%, more preferably from 20 to 100%. When a gas having a titanium tetrachloride concentration of 10% or more is used as a raw material, many uniform nuclei are generated or the reactivity is elevated and, as a result, the CVD-governed formation of grown particles hardly occurs and particles having a narrow particle size distribution can be obtained.

The gas for diluting titanium tetrachloride in the titanium tetrachloride-comprising gas is preferably selected from those neither reacting with titanium tetrachloride nor being oxidized. Specific examples of the preferred diluting gas include nitrogen and argon.

The preheating temperature of the titanium tetrachloride-comprising gas and oxidizing gas is preferably 500°C or more, more preferably 800°C or more. If the preheating temperature is less than 500°C, this gives rise to little generation of uniform nuclei and low reactivity and therefore, particles having a broad particle size distribution are obtained.

In introducing the titanium tetrachloride-comprising gas and oxidizing gas into a reaction tube, the flow velocity is preferably 10 m/sec or more because, by increasing the flow velocity, the mixing of two gases is accelerated. The flow velocity is more preferably from 20 to 200 m/sec, still more preferably from 50 to 150 m/sec. When the temperature at the introduction of gases into a reaction tube is 500°C or more, the reaction is completed at the same time with the mixing, so that the generation of uniform nuclei can be increased and the zone where CVD-governed formation of grown particles occurs can be shortened.

The raw material gas is preferably introduced into a reaction tube so as to attain thorough mixing of the gases introduced into the reaction tube. The fluid state of gas within the reaction tube is not particularly limited as long as the gases are thoroughly mixed, but, for example, a fluid state causing turbulence is preferred. A spiral vortex may also be present therein.

As for the introduction nozzle for introducing the raw material gas into the reaction tube, a nozzle giving a coaxial parallel flow, an oblique flow or a cross flow is employed, but the present invention is not limited thereto. A coaxial parallel flow nozzle is generally preferred in view of design because the structure is simple, though this nozzle is inferior in the mixing degree to the nozzles of giving an oblique flow or a cross flow.

For example, in the case of a coaxial parallel flow nozzle, the titanium tetrachloride-comprising gas is preferably introduced into the inner tube. In this case, the inner tube diameter is preferably 50 mm or less, more preferably 30 mm or less, from the standpoint of mixing the gases.

The gases introduced into the reaction tube each preferably flows at a high flow velocity within the reaction tube so as to attain complete mixing of gases. Particularly, the flow velocity is preferable 5 m/sec or more, more preferably 8 m/sec or more, in terms of the average flow velocity. When the gas flow velocity within the reaction tube is 5 m/sec or more, thorough mixing can be attained in the reaction tube. Also, the CVD-governed formation of grown particles occurs less and this prevents production of particles having a broad particle size distribution.

The reaction within the reaction tube is an exothermic reaction, and the reaction temperature is higher than the sintering temperature of fine particulate titanium dioxide produced. Therefore, unless the reaction product is rapidly cooled after the reaction, sintering of the produced fine particles proceeds to give grown particles, despite release of heat from the reactor. In the case of obtaining ultrafine particulate titanium dioxide of less than 10 $m^2$/g, it is preferred that the high-temperature residence time within the reaction tube exceeding 600°C is set to 1 second or less, more preferably 0.5 seconds or less, and the reaction product is rapidly cooled. For rapidly cooling the particles after the reaction, for example, a method of introducing a large amount of cooling air or gas such as nitrogen into the reaction mixture or spraying water is employed.

When the 90% cumulative mass-particle size distribution diameter D90 in the particle size distribution as measured by the above-described method is small, the synthesized titanium dioxide is judged to reveal good dispersibility in a hydrophilic solvent. Also, the fine particulate titanium dioxide produced by such a method is excellent in the uniformity of particle size. Furthermore, the fine particulate titanium dioxide used as the raw material in the present invention preferably comprises, as the main phase, an anatase crystal or a brookite crystal.

Assuming that the mass of the necking particle group is X, the dry mass of Particle Group G is Y and the mass of the entire oxide dispersion is Z, the solid content concentration (X+Y)/Z is preferably 0.02 to 0.4. If the ratio (X+Y)/Z is less than 0.02, a sufficiently large amount of oxide particles cannot remain on the substrate after the film formation and a satisfactory photocatalytic performance is sometimes difficult to exert. The oxide dispersion of the present invention exhibits excellent coatability even at a high concentration as compared with conventional products, but if the solid content concentration exceeds 0.4, a thick film is formed and due to difference in the drying rate between the outermost face of the film and the contact face on the substrate side, a stress is readily generated to cause cracking in the film, as a result, a sufficiently high film strength can be hardly maintained. The ratio (X+Y)/Z is more preferably from 0.05 to 0.35.

Also, in the liquid dispersion according to a preferred embodiment of the present invention, when the necking particle group and the particle group having few necking structures are present to satisfy that X/Y is from 30 to 0.1 and (X+Y)/Z is from 0.02 to 0.4, the effect of the present invention is obtained even if a particle group (for example, Particle Group H) as a third component is additionally present. Particle Group H includes the above-described Particle Group A added for enhancing the electrode performance. The presence of Particle Group H is preferred in some cases but is not essential. Assuming that the mass of Particle Group H is P, P/X is preferably 1.5 or less, more preferably 1 or less. If the amount of Particle Group H is too large, the aggregated particle diameter totalizing the blended necking particle group, particle group having few necking structures and Particle Group H becomes large and a uniform film is sometimes not easily obtained. In addition, the same bad effects as those described above for the case of too much blending of Particle Group A are caused in some cases.

The necking particle group and the particle group less having a necking structure are in many cases differing in the particle size distribution, but on considering the filling, film uniformity and the like, the raw material particularly of the necking particle group preferably has particle size uniformity to a certain extent.

The uniformity of the titanium dioxide particle size can be specified by its distribution constant (n) determined according to the Rosin-Rammler formula. The Rosin-Rammler formula is briefly described below, but details thereof are described in Ceramic Kogaku Handbook (Ceramic Engineering Handbook), compiled by the Ceramic Society of Japan, 1st ed., pp. 59-62 and pp. 596-598.

The Rosin-Rammler formula is represented by the following formula (3):

$$R = 100 \exp\{-(D/De)^n\} \qquad (3)$$

wherein D is a particle diameter, R is a mass percentage of particles larger than D (particle diameter) to all particles, De is a particle size characteristic number, and n is called a distribution constant which is a particle diameter corresponding to R=36.8 (%).

When formula (3) is modified, the following formula (4) is obtained.

$$\log\{\log(100/R)\}=n\log D+C \qquad (4)$$

wherein C is a constant (C=log·loge-nlogDe).

From formula (4), when logD and log{log(100/R)} are graduated on the x axis and on the y axis, respectively, of the Rosin-Rammler (RR) chart and the relationship therebetween is plotted, a nearly straight line is obtained. The gradient (n) of this straight line indicates the degree of uniformity of the particle size. As the numerical value of n is larger, the particle size distribution is judged as narrower.

The distribution constant n by the Rosin-Rammler formula of titanium dioxide for use in the preferred embodiment of the present invention is preferably 1.5 or more, and more preferably from 1.7 to 3.5.

Examples of the particle having a small particle diameter and high crystallinity include a brookite crystal-comprising titanium dioxide and an anatase crystal-comprising titanium dioxide, which are described below.

The brookite crystal-type titanium dioxide or anatase crystal-type titanium dioxide as used in the present invention is a dispersion comprising titanium dioxide exhibiting at least the characteristic features of brookite crystal-type titanium dioxide or anatase crystal-type titanium dioxide described, for example, in Manabu KIYONO, Sannka Titan (Titanium Dioxide), Gihodo, p. 129 (1991). Not only the brookite-type titanium dioxide or anatase crystal-type titanium dioxide but also a rutile crystal-type titanium dioxide may be comprised. An amorphous phase may also be comprised. These phases each may be dispersed as a single phase in the coating solution, or particles comprising a plurality of crystal phases may be dispersed. It is preferable that the presence of a crystal phase apparently having a characteristic feature of brookite type or anatase type can be confirmed.

In a simplest and practical method for confirming the presence of brookite-type or anatase-type crystal phase, the coating solution is dried under reduced pressure at ordinary temperature or heated at a temperature slightly exceeding 100°C to remove the water content, and then subjected to a powder X-ray diffraction analysis.

When titanium dioxide comprising a brookite-type crystal phase is present in the coating solution, a characteristic diffraction line is seen at 2.90 with respect to the interplanar spacing d (Å) calculated from the diffraction angle of Cu-Ka1 line (with a measurement error of ±0.02 Å) (however, when an additive having a stronger diffraction line in the vicinity of this position, the characteristic diffraction line is not necessarily observed as a peak at that position but is judged as a part of a larger diffraction peak; similarly, the "diffraction line" used in the following does not necessarily mean to appear as a peak at that position).

The diffraction line of the brookite type is also observed at 3.51 and 3.46 other than 2.90, but when titanium dioxide comprising an anatase-type crystal phase is present in the coating solution, the spectral position is overlapped with the peak 3.51 of the anatase-type titanium dioxide, and these can be hardly separated. When anatase-type titanium dioxide is present, the peaks at d=3.51 (Å) can be hardly distinguished because of the above-described reason, but other than this, a peak of the anatase-type crystal phase can be relatively clearly observed in the vicinity of 2.38. In the case where rutile-type titanium dioxide is present, a clear peak appears in the vicinity of d=3.25 (Å). By comparing the brookite-peak of 2.90, anatase-peak of 2.38 and rutile-peak of 3.25, the certain presence of each crystal phase in the titanium dioxide can be confirmed or a relative abundance ratio can be estimated.

However, the relative intensities of these three peaks do not completely agree with the ratios of respective crystal phases comprised in titanium dioxide and therefore, the content of each crystal phase is preferably measured by using the Rietvelt method described in Izumi NAKAI et al., Funmatsu X-sen Kaiseki no Jissai (Practical Powder X-Ray Analysis), Asakura Shoten (2002).

For example, in the present invention, the Rietvelt analysis software "RIETAN-2000" produced by Fujio Izumi is used for confirming the ratio of each crystal. A divided type profile function is used for the fitting and assuming that three kinds of crystals, that is, brookite-type crystal, anatase-type crystal and rutile-type crystal, are present, the background, shift, lattice constant, FWHM value and ratio of each crystal phase are optimized until the analysis reliability factor Rwp value (ratio of difference between the measured value and the calculated value) becomes less than 8. By this analysis, the mass ratio of each crystal phase in the titanium powder obtained from the coating solution can be known.

When the ratio of the brookite crystal-type titanium dioxide in the titanium dioxide is 25 mass% or more, the electronic conductivity is enhanced more than that in using other fine particles by virtue of high crystallinity of the brookite crystal-type titanium dioxide sol and moreover, an electrode having good properties can be obtained owing to high dye-adsorbing ability of this crystal-type titanium dioxide. Also, this crystal has high dispersibility and smoothly fills the void formed between particles of Particle Group C when the metal oxide dispersion is film-formed as the electrode. The ratio of this crystal-type titanium dioxide is preferably 35 mass% or more, and a remarkably remarkable effect is obtained therefrom.

If the ratio of brookite crystal-type titanium dioxide is less than 10 mass%, the superior effect due to the presence of brookite crystal-type titanium dioxide cannot be obtained. If the ratio of the brookite crystal-type titanium dioxide exceeds 95%, the productivity of the sol is bad, and since crystalline particles are readily grown, fine particles serving the purpose of Particle Group D can be hardly produced. In this meaning, an anatase-type titanium crystal in excess of at least 5 mass% is preferably comprised.

The brookite crystal-comprising titanium dioxide sol used as Particle Group D is not particularly limited in its synthesis method but can be produced, for example, by the following method.

The brookite crystal-comprising titanium dioxide sol can be produced by the method described, for example, in JP-A-11-43327. As described in Journal of Material Chemistry, Vol. 11, page 1116 (2001), the synthesis of the brookite crystal-comprising sol is presumed to pass through an intermediate chloride, and the control of the chlorine concentration and temperature at the synthesis is important. For this purpose, a system using, as the raw material, titanium tetrachloride which generates hydrogen chloride upon hydrolysis is preferred, and an aqueous titanium tetrachloride solution is more preferred. In order to maintain an optimal chlorine concentration during the synthesis, the hydrogen chloride may be prevented from dissipation out of the system, for example, by applying a pressure, but the most effective method is to perform the hydrolysis by using a reflux condenser in the hydrolysis reaction tank. The brookite crystal-type titanium dioxide may be obtained in an organic solvent from a metal alkoxide raw material or the like by adjusting the hydrochloric acid concentration and the water concentration, but in view of easy control of reaction and raw material cost, the reaction medium is preferably water.

The temperature at the hydrolysis is preferably from 50°C to the boiling point of the aqueous titanium tetrachloride solution. If the temperature is less than 50°C, the hydrolysis reaction takes a long time. The hydrolysis is performed by elevating the temperature to this range and holding it for approximately from 10 minutes to 12 hours. This holding time can be shorter as the temperature at the hydrolysis is on the higher temperature side. In the hydrolysis of the aqueous titanium tetrachloride solution, a mixed solution of titanium tetrachloride and water may be heated to a predetermined temperature in the reaction tank, or titanium tetrachloride may be added thereto and heated to a predetermined temperature after previously heating water in the reaction tank. By this hydrolysis, brookite crystal-comprising titanium dioxide can be obtained. In order to elevate the brookite-type titanium dioxide content therein, a method of previously heating water in a reaction tank to a temperature of 75°C to the boiling point, adding titanium tetrachloride thereto, and performing the hydrolysis at a temperature of 75°C to the boiling point is preferred.

As the titanium dioxide particles in the brookite crystal-comprising titanium dioxide sol are smaller, the titanium dioxide thin film can have higher transparency. Also, in view of affinity for the solvent, the titanium dioxide particles are preferably crystalline. However, an excessively small titanium dioxide is difficult to produce. Therefore, the BET specific surface area of the titanium dioxide particle in the sol is preferably from 20 to 400 $m^2/g$, more preferably from 50 to 350 $m^2/g$, still more preferably from 120 to 300 $m^2/g$.

In the case where the residual ion intensity in the brookite crystal-comprising titanium sol immediately after the synthesis is large, the solution may undergo coagulative precipitation but, by passing the synthesized brookite crystal-comprising titanium dioxide through a washing step such as filtration using an electrodialysis desalting device or an ultrafiltration membrane, more complete dispersion can be obtained.

In the present invention, a metal oxide structure obtained by dry mixing a metal oxide powder having an average primary particle diameter of 100 to 500 nm as converted from the BET specific surface area (hereinafter referred to as Particle Group A), and a metal oxide powder having an average primary particle diameter of 10 to 40 nm (hereinafter referred to as Particle Group B) may also be used. The dry mixing as used herein means a method of mixing the powders without using a dispersion medium such as water or organic solvent. In the wet mixing using a dispersion medium, the energy generated due to collision, friction or the like diffuses not only into particles but also into the dispersion medium and therefore, a mechanochemical reaction difficultly occurs. The important point is to allow for proceeding of a mechanochemical reaction by dry mixing, and to cause necking of particles with each other.

One of indices showing the filling state of particles is a tap density. As the filling density elevates, the value increases. The tap density is measured by the following method.

An apparatus such as powder tester Type PT-D manufactured by Hosokawa Micron Corporation is used. A sample is filled in 100 $cm^3$-volume cup with an auxiliary cup and subjected to tapping 100 times by the powder tester. After the auxiliary cup is removed, the sample is exactly filled to 100 $cm^3$ and the mass (g) of the sample is measured. The tap density is obtained by dividing the mass (g) of the powder by 100.

In the present invention, the metal oxide structure obtained preferably has a tap density of 0.15 to 1 $g/cm^3$. If the tap density is less than 0.15 $g/cm^3$, this reveals insufficient filling density, whereas if the tap density exceeds 1 $g/cm^3$, the metal oxide structure is hardly dispersed when used as a dispersing element. The metal oxide structure dispersing element in the poorly dispersed state is reduced in the void portion of the metal oxide structure, and when a dye-sensitized solar cell is produced, the electrolyte scarcely diffuses into the metal oxide layer and this causes shortage of electrolyte inside the metal oxide layer. The shortage of electrolyte disturbs the smooth transfer of electric charge.

For the dry mixing, for example, a ball mill, a high-speed rotary grinder, a stirring mill or a jet grinder may be used. As long as an energy causing a mechanochemical reaction in the particle groups is imparted, any well-known mixing procedure may be used, and any mill or grinder may be used, but the equipment used is preferably formed of a less contaminating material. In the following, an example of using a rolling ball mill among ball mills is described.

The rolling ball mill is a most general-purpose mixing and grinding method, and utilizes the collision, frictional action or the like between the powder particle and the medium in the container, which occurs when a cylindrical container rolls. In this case, the energy constant k which has been proposed as an index for the unified evaluation of the mixing and grinding effect by a rolling ball mill (L.D. Hart and L.K. Hadson, The American Ceramic Society Bulletin, 43, No. 1 (1964)) is represented by the following formula:

$$k = wm/wp \times d \times n \times t$$

(wherein wp represents the total mass (g) of powders mixed, wm represents the mass (g) of medium, d represents the container inner diameter (m) of ball mill, n represents the rotation number (rpm), and t represents the mixing time (minutes)).

As the energy constant elevates, the collision or friction energy imposed on the powder increases and the mechanochemical reaction proceeds and, as a result, aggregation takes place more vigorously.

In the method for producing a metal oxide structure according to the preferred embodiment of the present invention, assuming that the energy constant at dry mixing is k, k1 is preferably from 3,000 to 250,000. If the energy constant k1 is less than the lower limit, the mechanochemical reaction proceeds insufficiently and the particles are less bound with each other, whereas if the energy constant k1 exceeds the upper limit, the mechanochemical reaction proceeds but the metal oxide structure used as a dispersing element is hardly dispersed and the obtained metal oxide structure is reduced in the void portion. The reduction in the void portion adversely affects the diffusion of electrolyte when a dye-sensitized solar cell is produced, and decreases the performance of the solar cell. Furthermore, an excessive mechanochemical reaction extremely lowers the conduction band energy level of metal oxide structure, and when a solar cell is produced, the open voltage decreases to cause reduction in the photoelectric conversion efficiency.

In other mixing methods, the conditions are also preferably adjusted to give an energy sufficiently high to cause a mechanochemical reaction in the particle groups mixed. For example, the mechanochemical reaction may be allowed to proceed by adjusting the rotation number, the residence time or the like in the case of a high-speed rotary grinder; by adjusting the stirring rate, the mass of medium, the stirring time or the like in the case of a stirring mill; and by adjusting the pressure of carrier gas, the residence time or the like in the case of a jet grinder.

For detecting the mechanochemical reaction, a method of measuring the change in the optical band gap (hereinafter simply referred to as BG) between before and after dry mixing is known.

The change in BG of metal oxide is considered to occur because the molecular orbital in the vicinity of metal oxide particle surface is changed by the mechanochemical reaction. The particles differing in the primary particle diameter differ also in the lattice state on the particle surface and therefore, difference is present in BG. When particles differing in BG are bound with each other by the mechanochemical reaction, a new molecular orbital is generated to give a value different from BG before the mechanochemical reaction. Also, a phenomenon that crystallinity on the particle surface decreases and BG changes can occur. Therefore, by measuring the difference in BG between before and after dry mixing (hereinafter simply referred to as $\Delta$BG), the binding or surface state of a particle of Particle Group A and a particle of Particle Group B can be specified. The method for measuring BG and $\Delta$BG is described below.

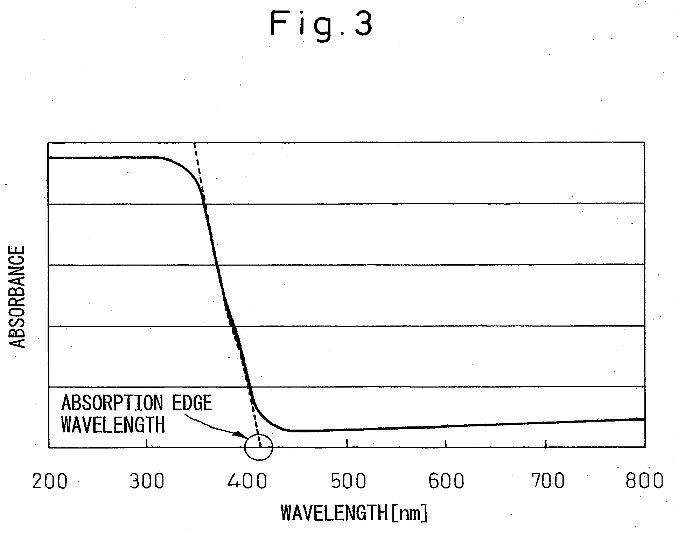

The relationship between the wavelength and the absorbance is measured by using, for example, an integrating sphere-type spectrophotometer Model UV-2400 or ISR-240A manufactured by Shimadzu Corporation. A tangent line is drawn with respect to inflection points of the obtained absorbance pattern (see, Fig. 3) and the point (absorption edge wavelength) where the tangent line and the wavelength axis are crossed is read. Fig. 3 shows one example of the relationship between the absorbance pattern and the absorption edge wavelength.

BG is represented by the following formula:

$$E = 1240/\lambda$$

(wherein E represents BG [eV], and $\lambda$ represents the absorption edge wavelength [nm]) and therefore, assuming that BG and absorption edge wavelength before dry mixing are BG0 [eV] and $\lambda$0 [nm], respectively, and BG and absorption edge wavelength after dry mixing are BG1 [eV] and $\lambda$1 [nm], respectively, the BG values before and after dry mixing are respectively as follows:

$$BG0 = 1240/\lambda0$$

and

$$BG1 = 1240/\lambda1.$$

Accordingly, $\Delta BG$ [eV] between before and after dry mixing is represented by the following formula:

$$\Delta BG = BG0-BG1 = (1240/\lambda0)-(1240/\lambda1)$$

In general, the anatase-type titanium dioxide is known to have BG of 3.2 eV (see, Kazuhito HASHIMOTO and Akira FUJISHIMA (compilers), Sanka Titan Hikari Shokubai no Subete (All Aspects of Titanium Dioxide Photocatalyst), CMC (1998)). However, the BG is liable to decrease by the mechanochemical reaction.

Other metal oxides or a mixture thereof show the same BG decreasing tendency.

In the production method according to the preferred embodiment of the present invention, $\Delta BG$ between before and after dry mixing of the obtained metal oxide structure is preferably from 0.01 to 0.45 eV. If $\Delta BG$ is less than 0.01 eV, this reveals less binding of particles with each other and the electron transfer among particles scarcely occurs. If $\Delta BG$ exceeds 0.45 eV, the crystallinity on the particle surface greatly decreases and this causes not only reduction in the electron transfer speed but also serious decrease in the conduction band energy level of metal oxide structure and, as a result, when a solar cell is produced, the open voltage decreases to cause reduction in the photoelectric conversion efficiency.

The titanium dioxide structure according to the preferred embodiment of the present invention is preferably characterized in that BG1 is from 2.7 to 3.1 eV.

Binder

In the present invention, when the film-formed titanium dioxide electrode is required to have strength, the metal oxide dispersion may comprise a binder. The binder means a substance which can play a role of, when added in a small amount, fixing the metal oxide particles in the state of being contacted with each other even after the solvent is removed from the metal oxide liquid dispersion. Accordingly, those having such a function can be used without limitation as a binder.

The above-described binding component is not necessary when the temperature is relatively high to cause melt-bonding of the particle group. However, in the case where the temperature of causing melt-bonding of the particle group is very high as in a ceramic, this technique can be applied only to a glass substrate having a high melting point resistant to such a high temperature. In industrially producing an electrode, the heating temperature is preferably lower in view of productivity and energy cost. A film having practical strength is sometimes difficult to obtain by using only the particle groups and therefore, an organic or inorganic component capable of giving strength at a lower temperature is generally used. As the ratio of the binding component to the particle group is larger, the film can have higher strength. However, with increase in the ratio of the binding component blended, the originally aimed function as the oxide particle electrode of the particle group is generally inhibited. Furthermore, in many cases, the active site of the particle group for expressing a function such as dye adsorption is a chemically specific point and the binding component in particular preferentially adheres thereto. Therefore, in the light of obtaining a sufficiently high film strength and fully exerting the objective function of the film, there is a trade-off relationship between the amount of the particle group and the amount of the binding component. Also, the binding component is mostly expensive as compared with the particle group and its use in a large amount is not preferred.

Specific examples of the organic binder include one or a mixture of polymer compound(s) selected from poly-N-vinylacetamide, N-vinylacetamide-sodium acrylate copolymer, N-vinylacetamide-acrylamide copolymer, polyacrylamide, acrylamide-sodium acrylate copolymer, poly-N-vinylformamide, polytetrafluoroethylene, tetrafluoroethylene-polypropylene fluoride copolymer, tetrafluoroethylene-polyfluoroalkyl vinyl ether copolymer, polyvinyl fluoride, polyvinylidene fluoride, a styrene-butadiene copolymer, polyvinylpyridine, vinylpyridine-methyl methacrylate copolymer, polyvinylpyrrolidone and polyvinylcaprolactam, and copolymer of the monomer of these polymer compounds. Among these, preferred are one or a mixture of polymer compound(s) selected from poly-N-vinylacetamide, polyacrylamide, N-vinylacetamide-sodium acrylate copolymer, acrylamide-sodium acrylate copolymer, polyvinylpyrrolidone, polyvinylcaprolactam and polytetrafluoroethylene, and a copolymer of the monomer of these polymer compounds. As the molecular weight is higher, the performance of the binder is more enhanced. To speak specifically, the average molecular weight is preferably 500 or more, more preferably 10,000 or more, still more preferably 100,000 or more.

In the present invention, not only an organic binder but also an inorganic binder can be used. Examples of the inorganic binder include Zr compounds, Si compounds, Ti compounds and A1 compounds. Specific examples thereof include zirconium compounds such as zirconium oxychloride, zirconium hydroxychloride, zirconium nitrate, zirconium sulfate, zirconium acetate, ammonium zirconium carbonate and zirconium propionate; silicon compounds such as alkoxysilane, partial hydrolysate of alkoxysilane with mineral acid, and silicate; metal alkoxides of aluminum, titanium or zirconium, and partial hydrolysates thereof with mineral acid; and those obtained by selecting multiple metal species from alkoxides of aluminum, silicon, titanium or zirconium, and compounding or hydrolyzing them. Among these, zirconium compounds are preferred. These binders may be used as a mixture, irrespective of organic or inorganic, to enhance the properties of respective binders.

The amount of the binder used is preferably smaller in the range of expressing the binding performance. More specifically, the binder is preferably added in an amount of 0.01 to 20 parts by mass, more preferably from 0.01 to 5 parts by mass, per 100 parts by mass of the metal oxide fine particle. In particular, the binder when used in a small amount of 0.01 to 2 parts by mass preferably imparts a pencil scratch strength of H or more, more preferably from 3H to 7H, to the metal oxide film, because the metal oxide film can have high mechanical strength without causing reduction in the electrical conductivity due to the binder. Also, the binder preferably does not comprise a functional group (that is, a hydroxyl group or an amino group) which may prevent the sensitizing dye from being supported on the metal oxide. More specifically, polyvinyl alcohol, polyamine and the like may sometimes cause reduction in the performance of the electrode and therefore, these are not preferred.

Solvent

As for the solvent used in the liquid dispersion, any solvent can be used without limitation as long as it is a volatile liquid capable of dispersing metal oxide fine particles and dispersing, dissolving or swelling the binder, thereby accelerating the mixing of the metal oxide fine particles and the binder. More specifically, a volatile liquid having, in its skeleton, a carboxyl group, a ketone group, an aldehyde group, an amino group or an amido group, is preferred. For example, water, methanol, ethanol, butanol, propanol (1-propanol, 2-propanol), 2-methyl-2-propanol, hexanol, methyl cellosolve, ethylene glycol, acetic acid, acetylacetone, terpene oil and methylpyrrolidone may be used as a single substance or a mixture thereof.

For dispersing the metal oxide particles, water is preferred, whereas for enhancing the wettability to the resin substrate, a hydrophobic solvent, particularly an alcohol, is preferred. Therefore, a mixture of water and an alcohol is a preferred solvent. In particular, when an aqueous solution comprising 40 mass% or more of ethanol is used as the solvent, good wettability to an electrically conducting resin substrate can be obtained and furthermore, when 60 mass% or more of ethanol is comprised, drying after coating can proceed at a higher rate and this leads to high productivity. Also, when the solvent for the metal oxide dispersion is a liquid obtained by incorporating 50 mass% or more of butanol into a volatile solvent comprising an alcohol, acetonitrile or the like having affinity for butanol, the produced metal oxide dispersion can have high viscosity at ordinary temperature and high affinity for the electrically conducting resin substrate and can be film-formed by vaporizing the solvent in the vicinity of 100°C and therefore, this is suitable as a metal oxide dispersion to be film-formed on an electrically conducting resin substrate by using a squeegee method or the like.

In view of wettability (coatability) of the metal oxide dispersion to a resin substrate (electrically conducting resin substrate), the liquid droplet contact angle of the metal oxide dispersion to a resin substrate (electrically conducting resin substrate) is preferably from 0 to 60°, more preferably from 20 to 50°. The resin substrate is typically polyethylene terephthalate (PET) or polyethylene naphthalate (PEN) and therefore, the liquid droplet contact angle of the metal oxide dispersion as measured with polyethylene terephthalate (PET) is preferably 0 to 60°, more preferably 20 to 50°.

Method for Making a Metal Oxide Dispersion

As for the method for producing a metal oxide liquid dispersion by using metal oxide fine particles, a binder and a solvent, a commonly employed dispersion method can be used. Specific examples thereof include mortar, paint conditioner, homogenizer, ball mill, bead mill and ultrasonic stirrer.

Method for Confirming Necking State of Particle Group

With respect to the method for confirming that the particle group comprised in the metal oxide dispersion is in a satisfactory necking state, the electrode obtained from the dispersion is subjected to a so-called AC impedance measurement and the necking state can be defined by the imaginary number term of the measured impedance. The measuring method is described below.

A dispersion as the objective of measurement is coated on a transparent electrically conducting resin substrate (OTEC-110, produced by Tobi Co., Ltd., thickness: 125 $\mu$m) to have an area of 1 cm$^2$ and a dry thickness of 10 $\mu$m as measured by a contact-type film thickness meter, and dried at 150°C for 10 minutes. This electrode is dipped in a 50 vol% acetonitrile (guaranteed reagent, produced by Kanto Kagaku) and 50 vol% ethanol (guaranteed reagent, produced by Kanto Kagaku) mixed solvent solution of a ruthenium organic complex dye (Ru(dcbpy)$_2$(NCS)$_2$, produced by Kojima Chemical Reagents Inc.) at 20 to 25°C for 12 hours or more in a light-shielding environment, and lightly rinsed with acetonitrile. The resultant electrode is used as the sample for impedance measurement.

As for the counter electrode at the measurement, a transparent electrically conducting resin substrate after depositing platinum by sputtering to 50 nm on the electrically conducting surface is used. After applying a spacer of 30 $\mu$m to the counter electrode to adjust the distance between electrodes, 0.1 mol/liter of lithium iodide (produced by Kishida Chemical Co., Ltd., purity: 97%), 0.05 mol/liter of iodine (guaranteed reagent, produced by Kanto Kagaku) and 0.5 mol/liter of tetrabutylammonium iodide (produced by Acros Organics, purity: 98%) are injected into the space and left standing for 15 minutes to allow the permeation of electrolytic solution.

Using a xenon lamp (UXL-150D-S, manufactured by Ushio Inc.) as the light source, light of 100 mW/cm$^2$ is irradiated on the sample. An impedance analyzer (1280, manufactured by Solartron) is used as the measuring apparatus and set such that the DC potential is constant at an open circuit potential, the AC potential amplitude is constantly 10 mV, the frequency ranges from 10 kHz to 0.1 Hz in 10 logarithmic steps, and the number of integrations is 10 cycles.

In this measurement, one or more clearly detectable circular arcs may be present, but, for example, when three circular arcs are clearly observed, the circular arc appearing closest to the high frequency side is originated in the low overvoltage reaction on the counter electrode surface and the circular arc appearing closest to the low frequency side indicates the diffusion of electrolyte. The circular arc noteworthy in the present invention is a circular arc in the vicinity of 20 Hz presumed to indicate the electron transfer within the metal oxide porous body, that is, a circular arc including frequency of at least 20 Hz within the arc range.

Since electrode substrates having a similar property have resistance measurement values that are in inversely proportional to the electrode surface areas thereof, it is required to normalize the measurement values by multiplying the value by the surface area of the die-sensitized electrode in order to compare impedance of cells having different surface areas. For example, a die-sensitized solar cell having electrode surface area of 3 cm$^2$ and an imaginary number portion value of the impedance measurement of -3 is equivalent to one having an electrode surface area of 1 cm$^2$ and imaginary number portion value of the impedance measurement of -9. When the surface area of the die electrode is S cm$^2$, the value of this imaginary number part is preferably from -25 S to 0 $\Omega$, because, in this case, the electrode resistance is small and low resistance is obtained as a solar cell. The value is more preferably from -15S to -0.01S $\Omega$. The value is still more preferably from -9S to -0.1S $\Omega$, because, in this case, very good performance is obtained.

As a noticeable matter in the present invention, when a metal oxide dispersion comprising a necking particle group is used, good electron conductivity can be maintained despite film formation at a low temperature of 150°C, as a result, the absolute value of the impedance imaginary number part in the circular arc comes close to 0. The value of this imaginary number part is preferably from -25 to -0.01 $\Omega$, because the electrode resistance is small and when the metal oxide liquid dispersion is processed as a solar cell, low resistance is obtained. The value is more preferably from -15 to -0.01 $\Omega$, and in view of very high performance of the cell produced by using the liquid dispersion, still more preferably from - 9 to -0.01 $\Omega$.

Coating Method of Metal Oxide Dispersion

The thus-produced metal oxide dispersion may be coated directly on an electrically conducting resin substrate without performing a pretreatment, but for the purpose of enhancing the adhesion between the substrate and the metal oxide fine particle layer, the substrate may be subjected to a treatment such as ultraviolet irradiation, ozone cleaning, surfactant treatment, electrolytic oxidation, formation of undercoat layer, or a combination thereof. By applying such a treatment, when coating the metal oxide dispersion on the electrically conducting resin substrate, the wettability of the dispersion can be enhanced and in turn, the adhesion and film strength can be elevated. At the same time, the adhesion between the metal oxide particle and the substrate is intensified and good electronic conductivity can be attained.

Examples of the light source for the ultraviolet irradiation include a high-pressure mercury lamp, a black light, a low-pressure mercury lamp, a germicidal lamp and a fluorescent lamp. From the standpoint of enhancing the affinity between the metal oxide dispersion and the substrate by utilizing the photocatalytic activity of the semiconductor on the electrically conducting resin substrate such as ITO, a light source emitting ultraviolet rays at a wavelength in the vicinity of 250 nm, such as low-pressure mercury lamp and germicidal lamp, is preferred.

When an ozone cleaning device is used, the functional group of the oxide can be imparted to the resin surface, or the decomposition or removal of an organic material remaining on the semiconductor surface can be performed with good efficiency. The ozone cleaning device may be a commercially available device such as atmospheric pressure-type device used for washing a semiconductor substrate, an optical component, a display and the like, for example, under irradiation of strong ultraviolet rays, or pressure-type device used for washing tile, outer wall, sink and the like.

When a corona discharge surface treatment is applied, a polar group can be imparted to the resin surface layer and in turn, the adhesion and coatability can be enhanced. In this treatment, a commercially available device used for the surface modification of a resin poor in the surface functional group, such as polyester, polypropylene and polyethylene, can be used.

As for the surfactant, for example, a condensed phosphate, a lignin sulfonate, a carboxymethyl cellulose, a naphthalene sulfonate-formalin condensate, a polyacrylate, an acrylic acid-maleate copolymer, an olefin-maleate copolymer, an alkyldiphenyl ether disulfonate or a nonionic surfactant is used. Among these, a polyacrylic acid-based surfactant and a polyoxyethylene alkyl ether are preferred.

The affinity for solvent can be elevated by performing electrolytic oxidation in a highly diluted acid used as the electrolytic solution, while assigning the anode to the electrically conducting resin substrate. The mechanism of enhancing the wettability to the solvent is not clearly known, but it is presumed that when a voltage is applied to the vicinity of semiconductor (for example, ITO), the resin surface in the periphery thereof is oxidized, whereby the same effect as that by ozone irradiation or corona discharging is brought out. For example, there may be used a method of electrolytically oxidizing the electrically conducting resin substrate while applying a direct current by using an aqueous 1 mmol/L sulfuric acid solution as the electrolytic solution and using a counter electrode having a specific surface area sufficiently large for the electrically conducting resin under the conditions such that the inter-electrode distance between the electrically conducting resin and the counter electrode is about 5 cm and the inter-electrode voltage is 100 V.

In coating the metal oxide dispersion on the electrode, one other layer comprising metal oxide fine particles may be provided as the undercoat layer on the electrically conducting resin electrode. The thickness of the undercoat layer is preferably from 1 nm to 2 $\mu$m. If the thickness is less than 1 nm, the metal oxide fine particle layer as the undercoat layer cannot exert a satisfactory effect, whereas if it exceeds 2 $\mu$m, there arises a problem in the bending strength or the like. In particular, when the metal oxide film is formed to a thickness of 10 nm or more, by virtue of the property that the metal oxide as an undercoat has good affinity for each solvent as compared with the resin, good adhesion can be obtained between the metal oxide dispersion for electrode to be formed and the resin.

The undercoat layer can be formed, for example, by sputtering or vapor deposition or by using a coating solution. Among these, the method using a coating solution does not require special equipment and can be applied for production from a small laboratory level to an industrial level and therefore, this method is preferred.

The coating solution preferably comprises titanium dioxide fine particles, because, for example, the titanium dioxide fine particle has low toxicity and environmental load, a fine particle having high light transmittance for photocatalyst is relatively easily available to enable formation of a film on the order from few nm to few $\mu$m, and this particle does not disturb the channel of electrons from the dye side to the electrically conducting resin electrode and has excellent dispersibility in various solvents.

Among titanium dioxides, a titanium dioxide having a particle diameter like the above-described Particle Group D is preferred as the constituent of the coating solution for the undercoat layer. In the case where a film having higher transparency and high affinity for the metal oxide dispersion is required, a brookite crystal-type or anatase crystal-type titanium dioxide having good dispersibility and good affinity for an aqueous or organic solvent is preferred of the particles D.

The coating solution for formation of the undercoat layer preferably comprises an inorganic binder described above. Among the inorganic binders, when a coating solution comprising a zirconium compound, which does not inhibit the dispersibility of titanium dioxide, is used, an undercoat layer having high strength and high transparency can be film-formed at a relatively low temperature.

The coating solution for formation of the undercoat layer preferably comprises an organic solvent. Particularly, when comprising an organic solvent in an amount of 40 mass% or more, the coating solution can be reduced in the surface energy and prevented from being repelled on the electrically conducting resin, so that an undercoat layer free of unevenness and having high adhesive property can be formed.

The thus-formed undercoat layer has high hydrophilicity and high affinity for solvent and therefore, a metal oxide dispersion for the preparation of electrode can be coated directly thereon without applying any treatment, but in order to enhance the wettability of the undercoat layer, ultraviolet rays or the like may be irradiated. At this time, sunlight, a black light, a fluorescent lamp or the like may be used as the light source, but longer-wavelength light at a wavelength of 350 to 400 nm is industrially advantageous in the case of performing the ultraviolet irradiation, because the affinity for solvent is satisfactorily elevated with the wave-length which is longer than that for enhancing the affinity for solvent of the electrically conducting resin electrode.

In the present invention, immediately before coating the metal oxide dispersion for the preparation of electrode, ultrasonic irradiation may be applied to the dispersion. The synthesized metal oxide dispersion is initially in a good dispersed state, but aggregation sometimes proceeds on aging. The presence of coarse particles may cause a reduction in the film strength or in the dye-adsorbing ability, or may inhibit diffusion of the electrolyte. By irradiating an ultrasonic wave, the coatability onto the electrically conducting resin can be enhanced, and the performance as the electrode can be prevented from reduction. As for the method of irradiating an ultrasonic wave, the metal oxide dispersion for the preparation of electrode may be placed in a container made of a resin or the like, and externally irradiated with an ultrasonic wave by using a desktop-type or industrial unit-type ultrasonic disperser, or an immersion-type ultrasonic emitter may be used. The frequency may be 100 kHz, 40 kHz, 28 kHz or a combination thereof.

In order to enhance the photoelectric conversion efficiency, a method of mixing a light-scattering material in the metal oxide film and thereby enhancing the light absorption efficiency of the sensitizing dye is widely used. In this case, the photoactive electrode used is formed of a metal oxide film in which a light-scattering material comprising particles having a particle diameter of about a half of the visible light wavelength, namely, a particle diameter of 150 nm to 1 $\mu$m described above as the particle diameter of Particle Group A, is dispersed for the purpose of accelerating light scattering. In the dye electrode produced by using this photoactive electrode, the incident light is refracted multiple times through the light-scattering material and therefore, the apparent distance of the incident light progressing within the metal oxide increases, as a result, the ratio of light absorbed by the sensitizing dye increases. The particle used here for accelerating light scattering is usually the same as the metal oxide.

This method is convenient in view of the process because the metal oxide dispersion may be blended with Particle Group A and coated by the same method as in conventional techniques, but on the other hand, the dye electrode obtained by this method has a problem in that a part of the incident light is reflected in the vicinity of interface with the sheet-like electrode of the dye electrode, and expelled outside the dye electrode without being absorbed by the sensitizing dye, as result, the actually achievable photoelectric conversion efficiency is low as compared with the photoelectric conversion efficiency achieved when the incident light is completely absorbed. For overcoming this problem, it is necessary to use a photoactive electrode where the ratio of the light-scattering material to the metal oxide in the dye electrode is made small on the light-incoming side, namely, in the portion close to the electrically conducting resin substrate and, as it approaches the counter electrode from this portion, the amount of the light-scattering material is increased. In this case, a so-called multilayer-type photoactive electrode comprising two or more layers constructed so that the ratio of the light-scattering material in the photoactive electrode can increase from the electrically conducting resin substrate side to the counter electrode side, or a gradient-type photoactive electrode where the composition continuously changes may be considered more effective.

Another purpose of employing a multilayer-type or gradient-type photoactive electrode is to accelerate the diffusion of electrolyte within the dye electrode. That is, in the vicinity of the electrically conducting resin substrate, the metal oxide film is made dense, whereby the amount of the dye supported can be increased and the light absorption efficiency can be enhanced. On the other hand, on the side close to the counter electrode, to which light scarcely reaches, the metal oxide is made sparse to allow for smooth transfer of the electrolyte, whereby the electrolyte can efficiently transfer between the dye electrode and the counter electrode while effectively absorbing light and the efficiency of the dye-sensitized solar cell can be enhanced.

The thickness of the metal oxide film formed on the electrically conducting resin substrate is preferably from 0.1 to 100 $\mu$m, more preferably from 1 to 40 $\mu$m, still more preferably 2 to 10$\mu$m. As for the electrically conducting resin substrate used here, those having an electric resistance of 2,000 $\Omega/\square$ (square) or less and having a visible light transmittance of 30% or more can be used. Specifically, a resin (e.g., PET, PEN) having, on the surface thereof, an electric conductor such as indium tin oxide (ITO), zinc oxide or fluorine-doped tin oxide (FTO) is preferred.

The metal oxide electrode can be produced by a method of coating the dispersion on the electrically conducting resin by spray coating, spin coating, doctor blade coating, flow coating, roll coating or the like, and drying it to remove the solvent. The electrode obtained by the spin coating or flow coating is dense and excellent in the see-through property and can make the entire cell transparent, but in order to increase the film thickness and sufficiently capture the incident light in the electrode, the number of coatings must be increased to allow for satisfactory adsorption of dye as the photoactive substance within the electrode and therefore, the productivity decreases. On the other hand, the spray coating, doctor blade coating and roll coating are industrially usable and among these, the spray coating is preferred, because the dispersion can be continuously dried while coating it and the film thickness can be controlled by adjusting the coating time or spray amount per hour.

Solar cell having, as a constituent element, the electrode shaped from metal oxide dispersion and use thereof

This relates to a dye-sensitized solar cell comprising a structure where the metal oxide film face side of the dye electrode obtained by loading a sensitizing dye on the surface of the metal oxide electrode prepared from the metal oxide dispersion is opposed to the electroconductive face of a counter electrode having catalytic activity and electrical conductivity, and an electrolytic solution is filled between the dye electrode and the counter electrode.

As for the sensitizing dye supported on the metal oxide surface, dyes used in dye-sensitized solar cells can be widely used. Specific examples thereof include ruthenium-bipyridium complex, xanthene-based dyes, merocyanine dyes, porphyrin derivatives and phthalocyanine derivatives. The sensitizing dye is loaded on the photoactive electrode by a generally employed method of dissolving the sensitizing dye in an alcohol and dipping the photoactive electrode in the resulting solution. For the counter electrode used here, materials having an electric resistance of 2,000 $\Omega/\square$ or less and having catalytic activity can be used without limitation irrespective of transparent or opaque. The catalytic activity as used herein means to act to reduce the electrolyte oxidized on the photoactive electrode, with a small overvoltage on the counter electrode. Specifically, platinum, ruthenium, graphite and carbon black have this function. Accordingly, any one or multiple member(s) of these components must be present on the counter electrode in the portion coming into contact with the electrolytic layer.

Examples of the counter electrode include those obtained by kneading carbon fiber, vapor-phase-process carbon fibers, carbon nanotubes, VGCF (TM), graphite powder, carbon black or graphite with polytetrafluoroethylene, tetrafluoroethylene-polypropylene fluoride copolymer, tetrafluoroethylene-polyfluoroalkyl vinyl ether copolymer, polyvinylidene fluoride, polyethylene fluoride, styrene-butadiene rubber or the like, and shaping the kneaded product into a sheet, and also include a ruthenium mesh, a platinum plate, a platinum fiber and an electrode having loaded on the surface thereof platinum. Examples of the method for loading platinum on the surface include generally employed methods such as electrochemical technique (e.g., electrolytic plating using a platinum plating bath, electroless plating), mixing, vapor deposition, sputtering and reaction chemical technique. In the case where a semiconductor having photocatalytic ability, such as ITO and titanium dioxide, is used as the substrate to which a noble metal such as platinum and ruthenium is imparted, a solution comprising the noble metal in the form of ion or complex ion is coated on the substrate and light at a wavelength of causing excitation of the photocatalyst is irradiated, whereby a noble metal having catalytic ability for the oxidation-reduction of electrolyte can be imparted on the counter electrode substrate.

The electrolytic solution for use in the electrolytic layer is not particularly limited as long as it is usable for normal dye-sensitized solar cells, and specific examples thereof include those obtained by dissolving at least one electrolyte selected from tetrabutylammonium iodide, lithium iodide, methylethylimidazolium iodide, dimethylpropylimidazolium iodide and iodine in an aprotic polar solvent such as acetonitrile, ethylene carbonate, methoxypropionitrile, dimethoxyethane or propylene carbonate.

The solvent in which the electrolyte is dissolved may be a room-temperature molten salt alone where the cation is ethylmethylimidazolium, dimethylpropylimidazolium, butylmethylimidazolium, hexylmethylimidazolium, octylmethylimidazolium, decylmethylimidazolium, dodecylmethylimidazolium, tetradecylmethylimidazolium, hexadecylmethylimidazolium, octadecylmethylimidazolium, dimethylethylimidazolium, dimethylbutylimidazolium, dimethylhexylimidazolium or the like; and the anion is a halogen as represented by iodine, a boron tetrafluoride, a phosphorus hexafluoride, a salt of cation and anion, as represented by above and the like. Examples of the normal-temperature molten salt include ethylmethylimidazolium tetrafluoroborate, dimethylpropylimidazolium tetrafluoroborate, ethylmethylimidazolium iodide-aluminum iodide mixed system, dimethylpropylimidazolium iodide-aluminum iodide mixed system, ethylmethylimidazolium trifluoromethanesulfonate and dimethylpropylimidazolium trifluoromethanesulfonate, or a mixture thereof, or may be a mixture of the molten salt and an aprotic polar solvent.

The dye-sensitized solar cell comprising, as a constituent element, the electrode made of the metal oxide dispersion according to the preferred embodiment of the present invention may be equipped in an article having a function such as generation of light, heat, sound or the like, movement or display, and thereby utilized as a power source for the function not only under sunlight, room light or illumination light such as fluorescent lamp and incandescent lamp but also in an environment irradiated with light from various light sources. For example, an LED may also be used.

The dye-sensitized solar cell can also be utilized as a composite charging device combined with a well-known charging devise such as a lithium ion battery, nickel-hydrogen battery, lead storage battery, various chemical capacitors or an electrical double layer capacitor; a composite cooling device combined with a Peltier element; or a composite display device combined with a display element such as organic EL or liquid crystal. A composite device with a polymer cell may also be produced. The polymer cell comprises at least an electrode for taking out, as an electric energy, the electron donation and acceptance associated with an oxidation-reduction reaction of a compound, and an electrolytic solution or a solid or gel electrolyte, wherein the positive and negative electrode active substances constituting the electrode are a nitrogen atom-comprising $\pi$ conjugate polymer and/or quinine-basted compound of undergoing proton binding and desorption capable of participating in the electron donation and acceptance associated with the oxidation-reduction reaction, the electrolytic solution or solid or gel electrolyte comprises a proton, and the proton concentration of the electrolytic solution or sold or gel electrolyte and the operating voltage are set or controlled such that only the binding and desorption of proton bound or coordinated to the nitrogen atom or proton of the produced hydroxyl group participates in the electron donation and acceptance associated with the oxidation-reduction reaction of the positive and negative electrode active substances.

Particularly, when a resin is employed for the electrode substrate of the dye-sensitized solar cell, and the above-described element or component combined is also based on a flexible substrate, the obtained composite device can also be made flexible.

Examples of the article utilizing such a dye-sensitized solar cell or a composite device thereof include articles having a power-generating function, a charging function, a light-emitting function, a heat-generating function, a sound-generating function, a moving function or a display function, such as building materials, lighting equipment, decorative windowpane, machines, vehicles, glass products, home appliances, agricultural materials, electronic devices, cellular phones, beauty tools, handheld terminals, PDAs (Personal Digital Assistants), industrial tools, tableware, bath goods, toilet goods, furniture, clothing, cloth products, fiber, leather products, paper products, resin products, sporting goods, bedding, containers, spectacles, billboards, piping, wiring, metal fittings, hygiene materials, automobile equipment, stationery, emblems, hats, bags, shoes, umbrellas, window shades, balloons, piping, wiring, metal fittings, illumination, LEDs, signals, street lights, toys, road signs, ornaments, traffic lights, bulletins, outdoor products (e.g., tents, cooler boxes), artificial flowers, objet d'art, power sources for cardiac pacemakers, and power sources for heaters or coolers with Peltier elements.

Also, a learning material set or a DIY set may be provided by arranging members for constituting the production process of the dye-sensitized solar cell or a composite device thereof.

Metal Oxide Electrode

The metal oxide film according to the preferred embodiment of the present invention, which is formed on an electrically conducting substrate, is characterized by having a mechanical strength of H or more, preferably from 3H to 7H, as measured by a pencil scratch strength test according to JIS5600. If the mechanical strength is less than H, this reveals low adhesion of the metal oxide particle to the electrode substrate and the electron transfer from the metal oxide particle to the electrode substrate does not proceed smoothly, giving rise to decrease in the performance as a dye-sensitized solar cell. The upper limit of the mechanical strength is not limited from the aspect of performance of the dye-sensitized solar cell but, as the mechanical strength of glass is from 5H to 7H, the mechanical strength of the metal oxide film is preferably 7H or less in view of cost.

The metal oxide film according to the preferred embodiment of the present invention is preferably formed on an electrode substrate having flexibility. Even when the electrode substrate is constituted by glass or the like and the metal oxide film is formed on such a electrode substrate having no flexibility, this does not affect the performance of the dye-sensitized solar cell, but if the electrode substrate has flexibility, the dye-sensitized solar cell can be applied also for flexible applications and the application range is widened.

The metal oxide film according to the preferred embodiment of the present invention preferably comprises a binder having hydrophilicity. The binder as used herein means a substance having a function of, when a liquid dispersion or the like of metal oxide is coated and dried on a substrate or the like, enhancing the adhesion of metal oxide particles to each other or the adhesion of the metal oxide particle to the electrode substrate, and preventing generation of cracking during the film formation or separation of the film from the substrate. As the binder, any substance can be used without limitation as long as it produces chemical or physical bonding to a metal oxide and even after the removal of solvent from the metal oxide liquid dispersion, plays a role of fixing the metal oxide particles in the state of being contacted with each other. More specifically, a substance having both a hydrophobic main chain and a hydroxyl group, a carboxyl group, a carbonyl group, an amido group, an amino group, an imido group, an imino group or the other high-polarity functional group is preferred. In order to enhance the hydrophilicity, the substance as the binder may have an ester bond, an ether bond or the like. Examples of such a substance include one or a mixture of polymer compound(s) selected from poly-N-vinylacetamide, sodium polyacrylate, polyacrylamide, poly-N-vinylformamide, polytetrafluoroethylene, polyfluoroalkyl vinyl ether, polyvinyl fluoride, polyvinylidene fluoride, polyvinylpyridine, polyvinylpyrrolidone and polyvinylcaprolactam, and a copolymer thereof. Among these, preferred are poly-N-vinylacetamide, polyacrylamide, polyvinylpyrrolidone, a vinylpyrrolidone-acetamide copolymer, a vinylpyrrolidone-acrylamide copolymer and polytetrafluoroethylene. As the molecular weight is higher, the performance of the binder is more enhanced. To speak specifically, the average molecular weight is preferably 500 or more, more preferably 10,000 or more, still more preferably 100,000 or more.

The content of the binder comprised in the metal oxide film according to the preferred embodiment of the present invention is preferably from 0.005 mass% to less than 5 mass%. If the content of the binder comprised in the metal oxide film is less than 0.005 mass%, the adhesion of the metal oxide particle to the electrode substrate is insufficient, and the performance of the dye-sensitized solar cell decreases, whereas if the binder content is 5 mass% or more, the metal oxide is prevented from combining with the sensitizing dye, and then the performance of the dye-sensitized solar cell decreases. The content of the binder comprised in the metal oxide film is preferably from 0.01 to 2 mass%, more preferably from 0.01 to 1 mass%, but the binder content is preferably smaller and within the range of allowing for expression of the binder performance.

The present invention has been accomplished based on the finding that even with such a small amount of binder, when the binder is appropriately selected, the metal oxide film formed on an electrically conducting substrate can have a mechanical strength of H or more, preferably from 3H to 7H, as measured by a pencil scratch strength test according to JIS5600. According to the present invention, the binder content can be thus made small and therefore, in forming a metal oxide particle layer on an electrically conducting substrate as in conventional techniques, a metal oxide layer having a mechanical strength in a desired level while maintaining hi gh electron conductivity can be realized without using a binder or if used, without burning out the binder in the later baking step.

In the present invention, the necking structure in a preferred state, which is formed between metal oxide particles, is considered to contribute to the realization of a desired strength of the metal oxide film even with a small amount of binder.

According to the preferred embodiment of the present invention, the gist of the present invention resides in the finding that the mechanical strength by a pencil scratch strength test according to JIS5600 can be H or more, preferably from 3H to 7H, even with a small amount of binder and, as a result, the mechanical strength of the metal oxide layer can be enhanced while maintaining high electron conductivity of the metal oxide layer, and that this is very useful particularly in the application to a flexible resin substrate or the like. The metal oxide electrode according to the preferred embodiment of the present invention is used as an electrode in the state of comprising a binder.

The metal oxide film according to the preferred embodiment of the present invention preferably has a film thickness of 1 to 40 $\mu$m. If the film thickness is less than 1 $\mu$m, this causes insufficient scattering or absorption of light beams within the thin film, and the photoelectric conversion efficiency decreases, whereas if the film thickness exceeds 40 $\mu$m, the diffusion resistance of electrolyte becomes large or the transfer distance of electron becomes long and, as a result, the performance is not necessarily improved and moreover, the film forming operation is complicated.

The metal oxide film according to the preferred embodiment of the present invention preferably comprises at least two or more particle groups selected from a metal oxide particle group having a specific surface area of 1 $m^2$/g to less than 30 $m^2$/g as measured by the BET method, and a metal oxide particle group having a specific surface area of 30 to 500 $m^2$/g. The metal oxide having a specific surface area larger than 30 $m^2$/g has a function of adsorbing a sensitizing dye, and increasing the amount of electron generated. The metal oxide having a specific surface area of 30 $m^2$/g or less is used as a light-scattering material for the purpose of accelerating scattering of light within the metal oxide film, and enhancing the light absorption efficiency of the sensitizing dye. Inside the metal oxide film comprising a metal oxide having a specific surface area of 30 $m^2$/g or less, the incident light is refracted multiple times by the light-scattering material and therefore, the apparent distance of the incident light progressing within the metal oxide increases, as a result, the ratio of light absorbed by the sensitizing dye becomes high.

In the metal oxide film according to the preferred embodiment of the present invention, the metal oxide constituting the metal oxide film preferably comprises 30 mass% or more of a metal oxide synthesized by a vapor phase process. The vapor phase process as used herein means a method of reacting a metal chloride such as titanium tetrachloride with an oxidative gas such as oxygen at a high temperature. For example, when the metal oxide is titanium dioxide, this can be synthesized by the method described in WO01/16027, JP-A-6-304423, JP-B-36-3359, or the like. A so-called liquid-phase-process metal oxide obtained by wet-hydrolyzing a metal chloride or the like is low in heat history at the synthesis, and, as-is, has little formation of a necking structure to give bad electron transfer efficiency. But the metal oxide particle synthesized by a vapor phase process receives a large heat history at the synthesis and therefore, this metal oxide particle has high crystallinity and at the same time, has a necking bond to give a structure facilitated in the electron transfer and advantageous to the diffusion of an electrolytic solution.

As for the production method and properties of vapor-phase-process titanium dioxide, the above descriptions can be referred to.

The titanium dioxide preferably comprises anatase-type titanium dioxide or brookite-type titanium dioxide. Also, the BET specific surface area of titanium dioxide is preferably from 10 to 100 $m^2$/g, more preferably from 20 to 75 $m^2$/g. The particle size distribution of titanium dioxide is preferably sharp. The procedure for measuring the particle size distribution is specifically described below.

A slurry obtained by adding 50 ml of pure water and 100 $\mu$l of an aqueous 10% sodium hexametaphosphate solution to 0.05 g of titanium dioxide is irradiated with an ultrasonic wave (46 KHz, 65 W) for 3 minutes. Then, this slurry is subjected to the measurement of particle size distribution in a laser diffraction-type particle size distribution measuring apparatus (SALD-2000J, manufactured by Shimadzu Corporation). When the 90% cumulative weight-particle size distribution diameter D90 of the thus-measured particle size distribution is small, this is judged to reveal good dispersibility in a hydrophilic solvent. The 90% cumulative weight-particle size distribution diameter D90 of the present titanium dioxide, measured by the laser diffraction-type particle size distribution measuring method, is preferably 2.2 $\mu$m or less.

In the case of using the above-described titanium dioxide (Particle Group B) as the metal oxide fine particle, a different kind of titanium dioxide (Particle Group A) having a particle diameter of 100 to 500 nm in terms of the specific surface area is preferably used in combination at a mass ratio (A/B) of 0.01 to 0.5.

One of indices showing the filling state of particles is a tap density. As the filling density elevates, the value increases. The tap density is measured by the following method.

An apparatus such as powder tester Type PT-D manufactured by Hosokawa Micron Corporation is used. A sample is filled in 100 $cm^3$-volume cup with an auxiliary cup and subjected to tapping 100 times by the powder tester. After the auxiliary cup is removed, the sample is exactly filled to 100 $cm^3$ and the mass (g) of the sample is measured. The tap density is obtained by dividing the mass (g) of the powder by 100.

The metal oxide film of the present invention preferably comprises a metal oxide usable for dye-sensitized solar cells, such as titanium dioxide, or a mixture of at least two or more metal oxides of titanium dioxide, and a member selected from niobium oxide, tin oxide, zinc oxide, magnesium oxide, indium oxide, zirconium oxide, strontium titanate and barium titanate. In the case of constituting the metal oxide film from two or more semiconductors, titanium dioxide is preferably comprised in an amount of 10 mass% or more.

The metal oxide film of the present invention can be obtained by dispersing metal oxide particles and a binder in a solvent, coating the resulting liquid dispersion on an electrode substrate, and drying it.

Examples of the dispersion medium in which the metal oxide is dispersed include hydrophilic solvents such as water, ethanol, isopropanol, acetone, acetonitrile, tert-butanol or a mixed solvent thereof. In the case of using a resin for the electrode substrate, as the drying temperature at the drying step in the production of a dye-sensitized solar cell which is described later is from room temperature to 200°C, a dispersion medium having a boiling point of 200°C or less at atmospheric pressure is preferred, but this does not apply when the liquid dispersion is coated inside an apparatus for lowering the boiling point of the dispersion medium, such as a vacuum apparatus.

The method for dispersing the metal oxide in a solvent is not particularly limited as long as it uses a dispersing machine of mixing the metal oxide and the dispersion medium and at the same time, disaggregating the metal oxide aggregate, such as ball mill, high-speed rotary grinder, stirring mill, device utilizing ultrasonic wave generator, mortar, paint conditioner and homogenizer. In the dispersion treatment, the metal oxide, binder and dispersion medium may be simultaneously treated in a dispersing machine, or after previously kneading the metal oxide and binder, the resulting mixture may be dispersed in the dispersion medium. The binder may be dissolved and thereby diluted with a dispersion medium before use.

The method for coating a liquid dispersion having dispersed therein the metal oxide on an electrode substrate is not particularly limited as long as a metal oxide film having a uniform film thickness can be formed. Here, the viscosity of the obtained liquid dispersion varies depending on the content and kind of the metal oxide or binder comprised in the liquid dispersion and therefore, a coating method suitable for the viscosity of the liquid dispersion is preferably selected. For example, a coating method using a spin coater, an air spray device, an ultrasonic atomizer or the like is suited for the liquid dispersion having a viscosity of hundreds of mPa·s or less, a squeegee method, a doctor blade method or the like is suited for the liquid dispersion having a viscosity of thousands of mPa·s, and a screen printing method or the like is suited for the liquid dispersion having a viscosity of tens of thousands of mPa·s or more, but the relationship between the viscosity and the coating method is not limited to these examples.

The metal oxide film according to the preferred embodiment of the present invention is obtained by coating the above-described liquid dispersion on an electrode substrate and drying it. The drying method as used herein means to evaporate and remove the dispersion medium comprised in the metal oxide liquid dispersion from the metal oxide liquid dispersion film formed on the electrode substrate, and obtain a solidified metal oxide film. Therefore, in the drying step, any method may be used without limitation as long as the coating film of metal oxide is dried by the method. For example, a method of blowing a dry air on the coating film, a method of blowing a hot air by using a drier or the like, a method of irradiating infrared ray and a method of elevating the temperature of the electrode substrate are preferred, because the drying can be performed within a short time. However, in this case, the upper limit of the heat added to the electrode substrate must be the lower than the upper limit temperature where the binder can maintain its physical properties, and the heat-resistant temperature of the electrode substrate. To speak specifically, a range from room temperature to 200°C is preferred. The heat-resistant temperature as used herein means a lowest temperature causing occurrence of a phenomenon such as irreversible deformation, discoloration, reduction in mechanical properties or decomposition on the substrate. In the case of using a normal resin as the substrate, the softening or decomposition temperature of the resin is below the heat-resistant temperature.

The thus-obtained metal oxide film ensuring high mechanical strength, a large amount of generation of electron and good electron transferability, which is formed on the electrode substrate, is suitable for dye-sensitized solar cells.

The process of producing a dye-sensitized solar cell comprises a step of loading a sensitizing dye on the surface of the metal oxide constituting the metal oxide film of the present invention to obtain a dye electrode, a step of obtaining a counter electrode having catalytic activity and electrical conductivity, and a step of opposing the metal oxide film face side of the dye electrode to the electrically conductive face of the counter electrode, filling an electrolytic solution between the dye electrode and the counter electrode, and encapsulating the electrolytic solution. In the case where the electrode substrate used is a flexible electrode substrate, a separator is preferably inserted between two electrodes so as to prevent a short circuit between the dye electrode and the counter electrode.

As for the sensitizing dye supported on the metal oxide surface, dyes for use in dye-sensitized solar cells can be widely used. Specific examples thereof include ruthenium-bipyridium complex, xanthene-based dyes, merocyanine dyes, coumarin-based dyes, porphyrin derivatives and phthalocyanine derivatives. The sensitizing dye is loaded on the metal oxide by a generally employed method of dissolving the sensitizing dye in an alcohol and dipping an electrode substrate having a metal oxide film thereon in the resulting solution.

For the counter electrode, materials having an electric resistance of 2,000 Ω/□ or less and having catalytic activity can be used without Limitation irrespective of transparent or opaque. The catalytic activity as used herein means to act to reduce the electrolyte oxidized on the dye electrode, without producing an overvoltage on the counter electrode. Specifically, platinum, ruthenium, graphite and carbon black have this function. Accordingly, any one or multiple member(s) of these components must be present on the counter electrode in the portion coming into contact with the electrolytic layer. Examples of the counter electrode include those obtained by kneading carbon fiber, vapor-phase-process carbon fibers, carbon nanotubes, VGCF (TM), graphite powder, carbon black or graphite with a polytetrafluoroethylene, a tetrafluoroethylene-polypropylene fluoride copolymer, a tetrafluoroethylene-polyfluoroalkyl vinyl ether copolymer, a polyvinylidene fluoride, a polyethylene fluoride, a styrene-butadiene rubber or the like, and shaping the kneaded product into a sheet, and also include a ruthenium mesh, a platinum plate, a platinum fiber and an electrode having loaded on the surface thereof platinum. Examples of the method for producing such a counter electrode include generally employed methods such as mixing, vapor deposition, an electrochemical technique and a reaction chemical technique.

The electrolytic solution for use in the electrolytic layer is not particularly limited as long as it is usable for normal dye-sensitized solar cells, and specific examples thereof include those obtained by dissolving tetrabutylammonium iodide, lithium iodide, methylethylimidazolium iodide, methylpropylimidazolium iodide or iodine in an aprotic polar solvent such as acetonitrile, ethylene carbonate, methoxypropionitrile or propylene carbonate.

The separator is not particularly limited as long as it is electrically insulating, and neither disturbs the transfer of electrolyte nor reacts with the electrolyte or solvent. Specific examples thereof include cellulose-based, olefin-based, polyester-based, polyvinyl acetal-based, polyvinyl alcohol-based, polyamide-based, polyimide-based, polyacryl-based and polylactic acid-based porous membranes. Also, for example, a spherical organic polymer having a small particle size distribution, such as polyvinyl chloride and polyvinyl alcohol, or a spherical metal oxide such as titanium dioxide and aluminum oxide, may be mixed in the electrolytic layer and used as the separator.

In the thus-obtained dye-sensitized solar cell, a resin can be employed as the electrode substrate and when the element or component to be combined is also based on a flexible substrate, the obtained composite device can also be made flexible.

EXAMPLES

The present invention is described in greater detail below by referring to Examples and Comparative Examples, but the present invention is not limited thereto.

<Contact Angle Test>

Various metal oxide dispersions were dripped on a transparent electrically conducting resin substrate (OTEC-110, produced by Tobi Co., Ltd., thickness: 125 $\mu$m) or an FTO-glass electrically conducting electrode (Al10U80, produced by Asahi Glass Company, Ltd.), and the liquid droplet contact angle was measured by using a contact angle meter (CA-D, manufactured by Kyowa Interface Science Co., Ltd.).

<Preparation of Dye Solution>

In a mixed solvent comprising 50 vol% of acetonitrile (reagent chemicals, produced by Kanto Kagaku) and 50 vol% of ethanol (reagent chemicals, produced by Kanto Kagaku), 3 mmol/L of a ruthenium complex dye (Ru(dcb-py)$_2$(NCS)$_2$, produced by Kojima Chemical Reagents Inc.) was dissolved.

<Preparation of Electrolytic Solution>

In acetonitrile, 0.1 mol/liter of lithium iodide (produced by Kishida Chemical Co., Ltd., purity: 97%), 0.05 mol/liter of iodine (reagent chemicals, produced by Kanto Kagaku) and 0.5 mol/liter of tetrabutylammonium iodide (produced by Acros Organics, purity: 98%) were dissolved.

<Measuring Method of Photoelectric Conversion Efficiency>

Using a xenon lamp (UXL-150D-S, manufactured by Ushio Inc.) as the light source, light of 100 mW/cm$^2$ was irradiated on a dye-sensitized solar cell produced. The maximum photoelectric conversion efficiency at this time was measured by using a potentiostat (HAB151, manufactured by Hokuto Denko Corporation).

<Synthesis of Liquid-phase-process Titanium Dioxide Particle>

9.1 L of distilled water was charged into a reaction tank with a reflux condenser, heated to 95°C and kept at this temperature. While maintaining the stirring rate of about 200 rpm, 920 mL of an aqueous titanium tetrachloride solution (Ti content: 16.5 mass%, specific gravity: 1.52, produced by Sumitomo titanium Corp.) was added dropwise to the reaction tank at a rate of about 100 mL/min. At this time, the temperature of the reaction solution was carefully prevented from lowering. As a result, the titanium tetrachloride concentration was 0.5 mol/L (4 mass% in terms of titanium dioxide). In the reaction tank, the reaction solution became white turbid immediately after the dropwise addition, but the temperature was kept as-is. After the completion of dropwise addition, the temperature was elevated and the reaction solution was kept at a temperature (101°C) in the vicinity of the boiling point for 60 minutes. The obtained sol was washed with pure water by using an ultrafiltration membrane (Microsa ACP-1050, produced by Asahi Kasei Chemicals Corporation, pore size: about 6 nm) until the conductivity of the washing solution became 100 $\mu$S/cm, and then concentrated to give a solid content concentration of 10 mass% when dried at 120°C. It is found that the obtained particle has a distribution profile having a peak at 15 nm upon using the particle size distribution meter of lazar Doppler type according the above method. The BET specific surface area of the obtained solid content was measured by a BET specific surface area meter (Flow Sorb 2300, manufactured by Shimadzu Corporation) and found to be 220 m$^2$/g.

The dry solid content of this sol was ground in an agate mortar, and subjected to measurement by powder X-ray diffraction. The measuring apparatus used was an X-ray diffractometer (Rint Ultima+, manufactured by Rigaku Corp.). The measurement was performed by using CuKa1 as the X-ray source under the conditions such that the output was 40 kV-40 mA, the divergence slit was 1/2°, the divergence vertical limiting slit was 10 mm, the scattering slit was 1/2° and the light-receiving slit was 0.15 mm. The X-ray diffraction pattern was measured under FT condition with a scanning step of 0.04° and a measurement time of 25 seconds. The obtained X-ray pattern was analyzed by using the Rietvelt method described above and, as a result, the powder was found to be a brookite crystal-comprising titanium dioxide powder comprising 55 mass% of brookite crystal, 40 mass% of anatase crystal and 5 mass% of rutile crystal. The tap density P of the powder is 1.2g/cm$^3$. The necking number m of the thus produced liquid-process particle is 2.9 when the above equation (1) is used with assuming the true density p of titania of 4.0 g/cm$^3$. The primary particle size is about 7 nm when a transmission type electron microscope (JEM-200CX, produced by JEOL) is used to measure it.

Example 1: Dispersion Comprising Ethanol

Into a 800 cm$^3$-volume polyethylene container ($\phi$96 x 133 mm) of a ball mill (AV, manufactured by Asahi Rika Seisakusho), 3 g of vapor-phase-process titanium dioxide (Supertitania (registered trademark) G-2, produced by Showa Denko K.K.) having an average primary particle diameter of 500 nm, 9 g of titanium dioxide (Supertitania (registered trademark) F-4, produced by the same company) having an average primary particle diameter of 30 nm, 30 g of the liquid-phase-process titanium dioxide sol, 2 g of an aqueous 1% N-vinylacetamide-sodium acrylate copolymer (VIAC GE-195, produced by Showa Denko K.K.) solution, 6 g of water, 50 g of ethanol (pure chemical) and 500 g of 3 $\phi$ zirconia balls were charged, and mixed at a rotation speed of 80 rpm for 12 hours to obtain a titanium dioxide liquid dispersion.

Two sheets of transparent electrically conducting resin substrates (OTEC-110, produced by Tobi Co., Ltd., thickness: 125 $\mu$m) were prepared, and on one substrate, the contact angle test of the titanium dioxide dispersion obtained above was performed. Another substrate was masked with a tape to give a 5 mm-square coating area, and the titanium dioxide liquid dispersion obtained was coated and dried at 100°C for 10 minutes. By repeating the coating and drying, a titanium dioxide thin film of 10 to 12 $\mu$m was formed on the electrically conducting resin substrate.

This titanium dioxide thin film was dipped in a dye solution at 20 to 25°C overnight to adsorb the dye, thereby obtaining a dye electrode. A platinum counter electrode obtained by loading platinum on an electrically conducting glass substrate, and the dye electrode were fixed by facing respective active faces each other with a spacing of 30 $\mu$m, and an electrolytic solution was injected therebetween to produce an open-type dye-sensitized solar cell. The contact angle of the titanium dioxide dispersion, and the photoelectric conversion efficiency were measured, and the results are shown in Table 1.

For the film obtained from the metal oxide dispersion, impedance was measured according to the above procedure, and the minimum value of the imaginary number part of the measured impedance is -2.9 $\Omega$ in the circle including 20 Hz.

Example 2: Dispersion Comprising Butanol

The evaluation of contact angle, and the production and evaluation of a solar cell were performed in the same manner as in Example 1 except for using a mixed solvent comprising 40 g of 2-methyl-2-propanol and 10 g of ethanol in place of 50 g of ethanol. However, the dispersion obtained had a high viscosity and could be coated by the squeegee method.

Example 3: Dispersion Comprising Sodium Acrylate Polymer

The evaluation of contact angle, and the production and evaluation of a solar cell were performed in the same manner as in Example 1 except for using an aqueous 0.2 mass% sodium polyacrylate solution in place of the aqueous 1 mass% N-vinylacetamide-sodium acrylate copolymer solution.

Example 4: Dispersion Comprising Zirconium Compound

The evaluation of contact angle, and the production and evaluation of a solar cell were performed in the same manner as in Example 1 except for using a 8 g of an aqueous 20 mass% zirconium hydroxychloride solution (produced by Nippon Light Metal Co., Ltd.) in place of 2 g of the aqueous 1 mass% N-vinylacetamide-sodium acrylate copolymer solution and 6 g of water.

Example 5: Pretreatment by Ultraviolet Irradiation

5-1: Pretreatment of Electrically Conducting Resin Substrate

The transparent electrically conducting resin substrate was irradiated with light for 1 hour from a distance of 10 cm by using two 20-watt germicide lamps (produced by Toshiba Lighting and Technology Corp.). 5-2: Production of Solar Cell

The evaluation of contact angle, and the production and evaluation of a solar cell were performed in the same manner as in Example 1 except for using 50 g of water in place of 50 g of ethanol.

Example 6: Pretreatment by Ozone Cleaning

6-1: Pretreatment

As the pretreatment of the electrically conducting resin substrate, ozone irradiation was performed for 10 minutes by using a UV/O3 cleaning device (UV-1, manufactured by Samco).

6-2: Production of Solar Cell

The evaluation of contact angle, and the production and evaluation of a solar cell were performed in the same manner as in Example 1 except for using 50 g of water in place of 50 g of ethanol.

Example 7: Pretreatment by Corona Discharging

7-1: Pretreatment

As the pretreatment of the electrically conducting resin substrate, corona irradiation was performed at 10 kV for several seconds from the height of about 2 cm by using a corona irradiation device (Multidyne 1, manufactured by 3DT).

7-2: Production of Solar Cell

The evaluation of contact angle, and the production and evaluation of a solar cell were performed in the same manner as in Example 1 except for using 50 g of water in place of 50 g of ethanol.

Example 8: Pretreatment by Surfactant

8-1: Pretreatment

As the pretreatment of the electrically conducting resin substrate, the substrate was dipped in Surfactant E-100 (labomate, produced by Funakoshi Co., Ltd.) mainly comprising sulfo-fatty acid methyl ester salt and polyoxyethylene lauryl ethers, lightly shaken and then thoroughly washed with water.

8-2: Production of Solar Cell

The evaluation of contact angle, and the production and evaluation of a solar cell were performed in the same manner as in Example 1 except for using 50 g of water in place of 50 g of ethanol.

Example 9: Pretreatment by Electrolytic Oxidation

9-1: Pretreatment

As the pretreatment of the electrically conducting resin substrate, the substrate was cut into a rectangular shape of 2 cm x 4 cm and after dipping a 2 cm x 2 cm portion in an aqueous 1 mmol/L sulfuric acid solution, electrolytically oxidized at 100 V for several seconds by using a d.c. constant voltage generator under the conditions such that the counter electrode was a carbon electrode having a sufficiently large area and the interelectrode distance was 5 cm. At this time, it was confirmed by the ammeter equipped to the constant voltage generator that the flowing current was maximally 0.1 A or less.

9-2: Production of Solar Cell

The evaluation of contact angle, and the production and evaluation of a solar cell were performed in the same manner as in Example 1 except for using 50 g of water in place of 50 g of ethanol.

Example 10: Coating Method Using Undercoat Layer

10-1: Preparation of Undercoat Solution

In a 20 mL-volume glass beaker, 2 g of a sol comprising liquid-phase-process titanium dioxide particles and having a solid content of 10 mass%, 0.2 g of an aqueous 20 mass% zirconium hydroxychloride solution, 0.8 g of water and 7 g of ethanol were sequentially charged and stirred to obtain an undercoat solution.

10-2: Formation of Undercoat Layer

The coating solution prepared in 10-1 was coated on the electroconductive surface of the electrically conducting resin by flow coating, and after drying at ordinary temperature, cured at 100°C for 10 minutes. The obtained undercoat layer was subjected to ultraviolet irradiation for 5 minutes from a distance of 5 cm by using a 20-watt black light (produced by Toshiba Lighting and Technology Corp.).

10-3: Production of Solar Cell

Using the electrically conducting resin substrate having thereon the undercoat layer prepared in 10-2, the evaluation of contact angle, and the production and evaluation of a solar cell were performed in the same manner as in Example 1 except for using 50 g of water in place of 50 g of ethanol.

Example 11: Dye Electrode where Dispersions Differing in Composition were Stacked

11-1: Composition 1

Into a 800 $cm^3$-volume polyethylene container of a ball mill, 12 g of titanium dioxide having an average primary particle diameter of 25 nm, 30 g of liquid-phase-process titanium dioxide sol, 2 g of an aqueous 1% N-vinylacetamide-sodium acrylate copolymer solution, 6 g of water, 50 g of ethanol and 500 g of 3φ zirconia balls were charged, and mixed at a rotation ratio of 80 rpm for 12 hours to obtain a titanium dioxide liquid dispersion.

11-2: Composition 2

Titanium dioxide (10 g) having a particle diameter of 500 nm, 2 g of an aqueous 1% N-vinylacetamide-sodium acrylate copolymer solution and 56 g of water were mixed to obtain a titanium dioxide liquid dispersion. 11-3:

An electrically conducting resin substrate was masked with a tape to give a 5 mm-square coating area, and the titanium dioxide liquid dispersion Composition 1 obtained was coated and dried at 100°C for 10 minutes. By repeating the coating and drying, a titanium dioxide thin film of 8 μm was formed on the electrically conducting resin substrate. Subsequently, the titanium dioxide liquid dispersion Composition 2 was coated once and then dried to form a titanium dioxide thin film having a total film thickness of 10 μm.

This titanium dioxide thin film was dipped in a dye solution at 20 to 25°C overnight to adsorb the dye, thereby obtaining a dye electrode. A platinum counter electrode obtained by loading platinum on an electrically conducting glass substrate, and the dye electrode were fixed by facing respective active faces each other with a spacing of 30 μm, and an electrolytic solution was injected therebetween to produce and evaluate an open-type dye-sensitized solar cell. The photoelectric conversion efficiency was measured and the result is shown in Table 1.

Example 12: particle size distribution of dispersion

An oxide dispersion was prepared in the same manner as in Example 1 except for using F-4 in place of G-2. At this time, the 90% cumulative mass-particle size distribution diameter D90 in the particle size distribution of F-4 measured by the laser diffraction-type particle size measuring method was 0.9 $\mu$m and D50 was 0.5 $\mu$m. The n value according to the Rosin-Rammler formula was 2.0. Here, the n value was obtained by plotting three-point data D10, D50 and D90 obtained in the laser diffraction on the RR chart as R=90%, 50% and 10%, respectively, and determined from an approximate straight line drawn on these 3 points. The specific surface area was measured by the BET method and found to be 51 $m^2$/g. The primary particle diameter determined from this specific surface area value according to formula (2) was 29 nm. The tap density was 0.2 $g/cm^3$. The m calculated based on formula (1) was 230.

The liquid dispersion was measured with use of a laser Doppler-type particle size distribution meter. In the mass particle size distribution, peaks were present at 14 nm and 74 nm. The area of the peak at 14 nm was 65% and the area of the peak at 74 nm was 35%. When measured by the laser diffraction method, a mass particle size distribution having one peak at 1.9 $\mu$m was obtained. Also, the obtained dispersion was dried and the average primary particle diameter determined from the BET specific surface area of the resulting powder was 23 nm.

For this dispersion, the evaluation of contact angle, and the production and evaluation of a solar cell were performed in the same manner as in Example. Comparative Example 1: Aqueous Coating Method without Pretreatment

The evaluation of contact angle, and the production and evaluation of a solar cell were performed in the same manner as in Example 1 except for using 50 g of water in place of 50 g of ethanol. The dispersion after coating was poorly wetted to the electrically conducting resin substrate, and sometimes failed to adhere. Therefore, the coating was repeated, and an electrode usable for the production of a solar cell was selected and evaluated. Comparative Example 2: Dispersion Absent Particle Group A

The evaluation of contact angle, and the production and evaluation of a solar cell were performed in the same manner as in Example 1 except for using 3 g of titanium dioxide having an average primary particle diameter of 25 nm in place of 3 g of titanium dioxide having an average primary particle diameter of 500 nm.

Comparative Example 3: Dispersion Absent Particle Group D

The evaluation of contact angle, and the production and evaluation of a solar cell were performed in the same manner as in Example 1 except for using a mixture comprising 3 g of titanium dioxide having an average primary particle diameter of 25 nm and 27 g of water in place of 30 g of the liquid-phase-process titanium dioxide sol.

Comparative Example 4: dispersion comprising only Particle Group D

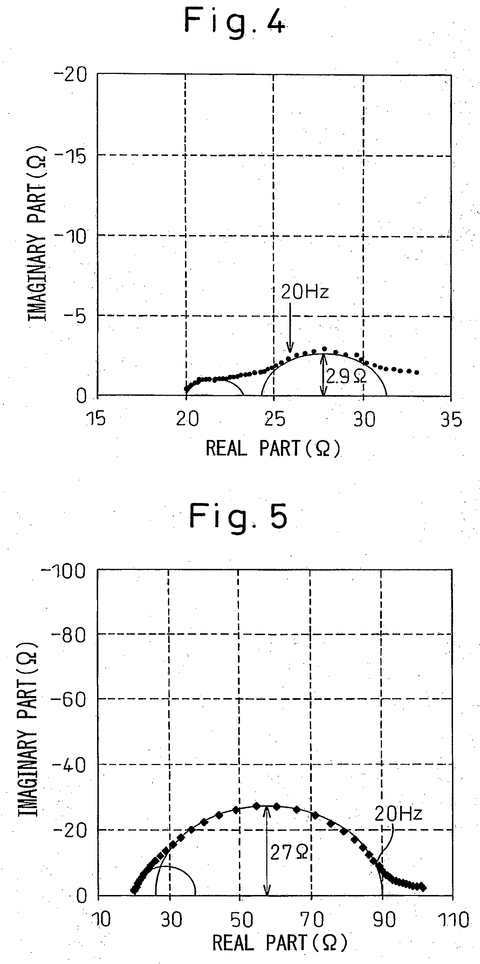

A liquid phase-grown titanium dioxide sol was dehydration-concentrated by using an ultrafiltration membrane and then adjusted such that the final solid content concentration as a dispersion was 15 mass%, the final solid content concentration of N-vinylacetamide-sodium acrylate copolymer was 0.02 mass%, and the final concentration of ethanol was 50 mass%. Subsequently, a film was formed from the resulting dispersion by a predetermined method and evaluated on the impedance. As shown in Fig. 5, the minimum value of the impedance imaginary number part in the circular arc including 20 Hz was -27 $\Omega$. Thereafter, the evaluation of contact angle and the production and evaluation of solar cell were performed in the same manner as in Example 1.

Table 1

|  | Contact Angle (°) | Conversion Efficiency(%) | Minimum Impedance ($\Omega$) |
|---|---|---|---|
| Ex. 1 | 42 | 2.9 | -2.9 |
| Ex. 2 | 37 | 3.0 | -3.1 |
| Ex. 3 | 46 | 2.7 | -3.5 |
| Ex. 4 | 41 | 2.6 | -4.1 |
| Ex. 5 | 18 | 2.6 | -3.1 |
| Ex. 6 | 83 | 2.8 | -3.6 |
| Ex. 7 | 75 | 2.8 | -4 |
| Ex. 8 | 97 | 2.6 | -3.5 |
| Ex. 9 | 66 | 2.9 | -3.2 |
| Ex. 10 | 16 | 3.1 | -4 |
| Ex. 11 | 42 | 3.0 | -3.3 |
| Ex. 12 | 41 | 2.5 | -3.2 |
| Comp. Ex. 1 | 98 | 2.4 | / |
| Comp. Ex. 2 | 43 | 2.0 | / |
| Comp. Ex. 3 | 45 | 1.9 | / |

(continued)

|  | Contact Angle (°) | Conversion Efficiency(%) | Minimum Impedance ($\Omega$) |
|---|---|---|---|
| Comp. Ex. 4 | 45 | 0.5 | -27 |

Example 13:

Into a 800 cm$^3$-volume polyethylene container ($\phi$96 x 133 mm) of a ball mill (AV, manufactured by Asahi Rika Seisakusho), 50 g of vapor-phase-process titanium dioxide (Supertitania (registered trademark) F-5, produced by Showa Denko K.K.), 0.5 g of poly-N-vinylacetamide (VIAC GE-191, produced by Showa Denko K.K.), 150 g of water and 500 g of 3$\phi$ zirconia balls were charged and dispersed at a rotation ratio of 80 rpm for 12 hours to obtain a titanium dioxide liquid dispersion. The obtained dispersion was coated on a glass electrode (Al10U80, glass with fluorine-doped tin oxide film, produced by Asahi Glass Company, Ltd.) by the doctor blade method (using a 70-micron applicator), and then left standing in a room for 2 hours to obtain a 10 $\mu$m-thick titanium dioxide film formed on an electrode substrate. The pencil scratch strength of this titanium dioxide film was 5H.

Subsequently, this titanium dioxide film was dipped in a dye solution for 12 hours to obtain a dye electrode, and excess metal oxide film was removed by using a cutter knife to give a metal oxide film size of 5x5 mm. Separately, platinum was loaded on another glass electrode of the same type as above to a thickness of 0.1 $\mu$m by a sputtering device to prepare a counter electrode. This counter electrode and the dye electrode prepared above were superposed one on another such that respective active faces came to the inner side, and the side faces of the glass electrodes were encapsulated with epoxy resin (Bond Quick 5, produced by Konishi Co., Ltd.). The thickness (about 40 $\mu$m) of the electrolyte layer was adjusted by interposing a tape-like spacer between two electrodes at both edges. Thereafter, an electrolytic solution was injected into the space between two electrodes through a fine hole previously made in the glass electrode to obtain a dye-sensitized solar cell. The injection port was closed with an epoxy resin similarly to the side faces. The photoelectromotive force of this solar cell was 4.0 mW/cm$^2$.

Example 14:

A titanium dioxide film was obtained in the same manner as in Example 13 except for blending 0.01 g of sodium polyacrylate (produced by Showa Denko K.K.) in place of the poly-N-vinylacetamide in Example 13. The pencil scratch strength of this titanium dioxide film was 3H. Using this titanium dioxide film, a dye-sensitized solar cell was produced in the same manner as in Example 13. The photoelectromotive force of this solar cell was 3.6 mW/cm$^2$.

Example 15:

A titanium dioxide film was obtained in the same manner as in Example 13 except that the titanium dioxide liquid dispersion after coating was dried in a drier at 120°C for 5 minutes instead of leaving it at room temperature. The pencil scratch strength of this titanium dioxide film was 6H. Using this titanium dioxide film, a dye-sensitized solar cell was produced in the same manner as in Example 13. The photoelectromotive force of this solar cell was 4.2 mW/cm$^2$.

Example 16:

A titanium dioxide film was obtained in the same manner as in Example 13 except for replacing the glass electrode of Example 13 with an ITO/PET film (OTEC-110, produced by Tobi Co., Ltd.). The pencil scratch strength of this titanium dioxide film was 5H. Using this titanium dioxide film, a dye-sensitized solar cell was produced in the same manner as in Example 13 except for inserting a 25 $\mu$m-thick cellulose-based separator between the dye electrode and the counter electrode. The photoelectromotive force of this solar cell was 3.9 mW/cm$^2$.

Example 17:

A titanium dioxide film was obtained in the same manner as in Example 13 except for using 80 g of titanium dioxide (Supertitania (registered trademark) F-5, produced by Showa Denko K.K.) and 20 g of zinc oxide (UFZ-40, produced by Showa Denko K.K.). The pencil scratch strength of this titanium dioxide film was 3H. Using this titanium dioxide film, a dye-sensitized solar cell was produced in the same manner as in Example 13. The photoelectromotive force of this solar cell was 3.3 mW/cm$^2$.

Example 18:

A titanium dioxide film was obtained in the same manner as in Example 13 except for coating the titanium dioxide liquid dispersion of Example 15 by a spin coating method (coating at a rotation ratio of 800 rpm for a rotation time of 3 seconds was repeated 8 times) in place of the doctor blade method. The pencil scratch strength of this titanium dioxide film was 6H. Using this titanium dioxide film, a dye-sensitized solar cell was produced in the same manner as in Example 13. The photoelectromotive force of this solar cell was 4.4 mW/cm$^2$.

Comparative Example 5:

A titanium dioxide film was obtained in the same manner as in Example 13 except for not adding poly-N-vinylacetamide to the metal oxide liquid dispersion. The pencil scratch strength of this titanium dioxide film was far less than H. Using this titanium dioxide film, a dye-sensitized solar cell was produced in the same manner as in Example 13, but a part of the titanium dioxide film was separated from the glass electrode in the process of forming a solar cell and therefore, the photoelectromotive force of this solar cell could not be measured.

Comparative Example 6:

A titanium dioxide film was obtained in the same manner as in Example 13 except for changing the amount of poly-N-vinylacetamide from 0.5 g to 0.005 g. The pencil scratch strength of this titanium dioxide film was less than H. Using this titanium dioxide film, a dye-sensitized solar cell was produced in the same manner as in Example 13. The photoelectromotive force of this solar cell was 1.4 mW/cm$^2$.

Comparative Example 7:

A titanium dioxide film was obtained in the same manner as in Example 13 except for changing the amount of poly-N-vinylacetamide from 0.5 g to 5.0 g. The pencil scratch strength of this titanium dioxide film was more than 7H. Using this titanium dioxide film, a dye-sensitized solar cell was produced in the same manner as in Example 13. The photoelectromotive force of this solar cell was 2.2 mW/cm$^2$.

**Claims**

1. A metal oxide dispersion comprising metal oxide particles with a necking structure in a solvent,
   wherein the liquid droplet contact angle of the metal oxide dispersion to an ITO film (Indium-Tin Oxide type film) is from 0 to 60°;
   wherein the solvent comprises water and ethanol, and the ethanol content is 40 mass% or more; and
   wherein the metal oxide particles comprise a metal oxide powder having an average primary particle diameter of 100 nm to 1 μm as converted from the BET specific surface area hereinafter referred to as Particle Group A, and a metal oxide powder having an average primary particle diameter of 5 to 40 nm as converted from the BET specific surface area hereinafter referred to as Particle Group B.

2. The metal oxide dispersion according to claim 1,
   wherein the ITO film is formed on a polyethylene terephthalate surface or polyethylene naphthalate surface.

3. The metal oxide dispersion according to claim 1 or 2, wherein the content of Particle Group A comprised in the metal oxide particle mixture is from 10 to 40 mass%.

4. The metal oxide dispersion according to any one of claims 1 to 3, wherein Particle Group B is a mixture of a metal oxide powder having an average primary particle diameter of 20 to 40 nm as converted from the BET specific surface area referred to as Particle Group C, and a metal oxide powder having an average primary particle diameter of 5 to 20 nm as converted from the BET specific surface area referred to as Particle Group D.

**Patentansprüche**

1. Metalloxiddispersion, die Metalloxidpartikel mit einer Einschnürungsstruktur in einem Lösungsmittel enthält, wobei der Kontaktwinkel von flüssigen Tröpfchen der Metalloxiddispersion an einem ITO-Film (Film vom Indium-ZinnOxid-Typ) 0 bis 60° ist;

wobei das Lösungsmittel Wasser und Ethanol enthält und der Ethanolgehalt 40 Massen-% oder höher ist; und wobei die Metalloxidteilchen ein Metalloxidpulver, das einen von der spezifischen Oberfläche nach BET umgewandelten mittleren Primärteilchendurchmesser von 100 nm bis 1 μm aufweist und im Folgenden als Partikelgruppe A bezeichnet wird, und ein Metalloxidpulver umfasst, das einen von der spezifischen Oberfläche nach BET umgewandelten mittleren Primärteilchendurchmesser von 5 bis 40 nm aufweist und im Folgenden als Partikelgruppe B bezeichnet wird.

**2.** Metalloxiddispersion nach Anspruch 1, wobei der ITO-Film auf einer Polyethylenterephthalatoberfläche oder einer Polyethylennaphthalatoberfläche gebildet ist.

**3.** Metalloxiddispersion nach Anspruch 1 oder 2, wobei der Gehalt der in dem Metalloxidteilchengemisch enthaltenen Partikelgruppe A 10 bis 40 Massen-% ist.

**4.** Metalloxiddispersion nach einem der Ansprüche 1 bis 3, wobei die Partikelgruppe B ein Gemisch eines Metalloxidpulvers, das einen von der spezifischen Oberfläche nach BET umgewandelten mittleren Primärteilchendurchmesser von 20 bis 40 nm aufweist und als Partikelgruppe C bezeichnet wird, und eines Metalloxidpulvers umfasst, das einen von der spezifischen Oberfläche nach BET abgeleiteten mittleren Primärteilchendurchmesser von 5 bis 20 nm aufweist und als Partikelgruppe D bezeichnet wird.

**Revendications**

**1.** Dispersion d'oxydes métalliques comprenant des particules d'oxydes métalliques ayant une structure avec formation de ponts dans un solvant,

dans laquelle l'angle de contact des gouttelettes liquides de la dispersion d'oxydes métalliques avec un film ITO (film de type oxyde d'indium et d'étain) est de 0 à 60° ;
dans laquelle le solvant comprend de l'eau et de l'éthanol, et la teneur en éthanol est de 40 % en masse ou plus ; et dans laquelle les particules d'oxydes métalliques comprennent une poudre d'oxydes métalliques ayant une granulométrie primaire moyenne de 100 nm à 1 μm, telle que convertie à partir de l'aire spécifique BET, appelée ci-après groupe de particules A, et une poudre d'oxydes métalliques ayant une granulométrie primaire moyenne de 5 à 40 nm, telle que convertie à partir de l'aire spécifique BET, appelée ci-après groupe de particules B.

**2.** Dispersion d'oxydes métalliques selon la revendication 1, dans laquelle le film ITO est formé sur une surface de poly(téréphtalate d'éthylène) ou une surface de poly(naphtalate d'éthylène).

**3.** Dispersion d'oxydes métalliques selon la revendication 1 ou 2, dans laquelle la teneur du mélange de particules d'oxydes métalliques en le groupe de particules A est de 10 à 40 % en masse.

**4.** Dispersion d'oxydes métalliques selon l'une quelconque des revendications 1 à 3, dans laquelle le groupe de particules B est un mélange d'une poudre d'oxydes métalliques ayant une granulométrie primaire de 20 à 40 nm, telle que convertie à partir de l'aire spécifique BET, appelée groupe de particules C, et d'une poudre d'oxydes métalliques ayant une granulométrie primaire moyenne de 5 à 20 nm, telle que convertie à partir de l'aire spécifique BET, appelée groupe de particules D.

# Fig.1

# Fig.2

# Fig.3

# Fig. 4

# Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001283942 A
- JP 2003308890 A
- JP 11288745 A
- JP 10112337 A
- WO 0116027 A
- JP 6304423 A
- JP 363359 B
- JP 2001357899 A
- JP 11043327 A

**Non-patent literature cited in the description**

- **M. GRAEZEL.** *Nature,* 1991, vol. 353, 737
- **C.J. BARBE et al.** *J. Am. Ceram. Soc.,* 1997, vol. 80, 3157
- **B.A. GREGG et al.** *Langmuir,* 2000, vol. 16, 5626
- **MANABU KIYONO.** *Sannka Titan (Titanium Dioxide),* 1991, 129
- Ceramic Kogaku Handbook (Ceramic Engineering Handbook). Ceramic Society of Japan, 59-62, 596-598
- **IZUMI NAKAI et al.** Funmatsu X-sen Kaiseki no Jissai (Practical Powder X-Ray Analysis). Asakura Shoten, 2002
- *Journal of Material Chemistry,* 2001, vol. 11, 1116
- **L.D. HART ; L.K. HADSON.** The American Ceramic Society Bulletin. 1964, vol. 43
- **KAZUHITO HASHIMOTO ; AKIRA FUJISHIMA.** Sanka Titan Hikari Shokubai no Subete (All Aspects of Titanium Dioxide Photocatalyst). CMC, 1998